# EUROPÄISCHE PATENTSCHRIFT

(11) **EP 3 617 721 B1**
(45) Veröffentlichungstag und Bekanntmachung des Hinweises auf die Patenterteilung: **15.03.2023**
(21) Anmeldenummer: 19193371.2
(22) Anmeldetag: 23.08.2019
(51) Int. Cl.: G01R 29/027, H02J 7/00

(54) **IMPEDANZERKENNUNG EINES VERBRAUCHERS AN EINER LADESTATION**
IMPEDANCE DETECTION OF A CONSUMER AT A CHARGING STATION
RECONNAISSANCE D'IMPÉDANCE D'UN CONSOMMATEUR D'UNE STATION DE CHARGE

(30) Priorität: 27.08.2018 DE 102018214450
(43) Veröffentlichungstag der Anmeldung: 04.03.2020
(73) Patentinhaber: BSH Hausgeräte GmbH, 81739 München (DE)
(72) Erfinder: Brust, Hans-Detlef, 66125 Dudweiler (DE); Wilhelm, Mario, 98544 Zella-Mehlis (DE); Kühnel, Markus, 97616 Bad Neustadt (DE)

(56) Entgegenhaltungen:
- EP-A1- 2 648 307
- DE-A1-102010 042 227
- GB-A- 2 555 939

## Beschreibung

Die Erfindung betrifft eine Ladestation (synonym auch "Basisstation" genannt) für einen Verbraucher, insbesondere Roboter mit den Merkmalen des Oberbegriffs des Anspruchs 1. Die Erfindung betrifft des Weiteren eine Anordnung umfassend die Ladestation und den Roboter sowie ein Verfahren.

Verbraucher, insbesondere energieautonome Verbraucher, z. B. akkubetriebene Handgeräte wie Staubsauger etc., insbesondere sich bewegende (Haushalts-)Roboter, z. B. Staubsaugroboter, Mähroboter, werden im Betrieb von einem Energiespeicher, insbesondere Akku gespeist und benötigen eine Lade- bzw. Basisstation, an der sie ihren Energiespeicher aufladen können. Die Basisstation verfügt dazu in der Regel über zwei Ladekontakte bzw. Elektroden, an der die Ladespannung anliegt und die sich mit den korrespondierenden Ladeelektroden einer Gegenschnittstelle des Verbrauchers verbinden können. Im Folgenden wird der vorliegende Sachverhalt und auch die vorliegende Erfindung streckenweise beispielhaft anhand eines Roboters erläutert, wobei sämtliche Ausführungen sinngemäß auf andere Geräte, insbesondere Handgeräte, übertragbar sind, die an Ladestationen andocken. Die Ladestation wird vom Roboter selbstständig und in der Regel unbeaufsichtigt angefahren, wenn der Ladezustand des Energiespeichers stark abgesunken ist. Außerdem dient die Basisstation meist auch als Ruhestation des Verbrauchers, wenn er seine Arbeit beendet hat. Für viele Verbraucher ist das Anliegen der Ladespannung an seinen Ladeelektroden zugleich ein Indiz dafür, dass sie ihre Ruheposition an der Basisstation erreicht haben.

Daher liegt an den meist frei liegenden Ladeelektroden der Basisstation die Ladespannung in der Regel kontinuierlich an. Falls ein metallischer Fremdkörper (z. B. eine Büroklammer, eine Metallfolie oder ein Stück metallischer Putzwolle) beide Elektroden berührt, kann es zu einem Kurzschluss kommen. Ein sehr niederohmiger "satter" Kurzschluss wird üblicherweise durch eine Schutzabschaltung oder Strombegrenzung des Netzteils der Basisstation, die ansprechen, wenn der erwartete Ladestrom deutlich überschritten wird, vermieden werden. Allerdings sind die Ladeströme beim Aufladen des Verbraucherenergiespeichers durchaus im Bereich mehrerer Ampere, so dass eine solche Schutzschaltung möglicherweise nicht ansprechen wird, falls das kurzschließende Metallteil einen entsprechenden nicht ganz niedrigen Widerstandwert aufweist. Ein Strom von mehreren Ampere kann aber schon ausreichen, ein kurzschließendes Metallteil bis zum Glühen zu erhitzen und dadurch einen Brand auszulösen bzw. zu zünden. Das gilt insbesondere dann, wenn ein leitender Fremdkörper noch leicht brennbare Anhaftungen wie Schmutz, Fett oder Öl oder Kunststoffe aufweist. Typische Beispiele für solche leitenden Fremdkörper sind metallische Putzwolle oder aber in Textilien eingewebte dünne Metallfäden. Die Gefahr, dass durch herabfallende oder versehentlich durch Haustiere zur Basisstation "verschleppte" Metallteile einen Kurzschluss erfolgt, ist dann besonders hoch, wenn sich die Ladeelektroden der Basisstation auf Bodenebene befinden. Aber auch bei seitlich angebrachten Kontakten kann z. B. durch in die Blusenärmel der Benutzerin eingewirkte Metallfäden ein Kurzschluss erfolgen, wenn die Benutzerin an der Basisstation hantiert.

Viele Verbraucher verfügen über Motoren, die Permanentmagnete enthalten. Deren magnetisches Feld zeigt nicht selten auch noch auf der Unterseite des Verbrauchers eine signifikante Feldstärke, so dass der Verbraucher selbst u. U. kleine Metallteile anziehen und dadurch bei seiner Bewegung durch einen Raum "aufsammeln" und selbst zur Basisstation verschleppen kann. Dieser Effekt erhöht noch deutlich die Wahrscheinlichkeit, dass ein metallischer Fremdkörper schließlich auf den Ladeelektroden der Basisstation landet.

Die Druckschrift EP 1 921 523 A2 beschreibt ein System, bei dem ohne Roboter an den Ladeelektroden der Basisstation nur hochohmig über einen genau spezifizierten Widerstand eine Spannung anliegt, so dass ein Kurzschluss allenfalls zu einem ungefährlich geringeren Stromfluss führt. Der Roboter enthält das Gegenstück zum Widerstand in der Basisstation, so dass nach dem Andocken des Roboters ein definierter Serienwiderstand entsteht und ein genau definierter Strom durch die beiden Widerstände fließt. Nur wenn genau dieser vorbestimmte Strom fließt, schalten sowohl Basisstation und Roboter in den Lademodus und die eigentliche Ladespannung mit hohem Ladestrom wird von der Basisstation an die Ladekontakte angelegt.

Aus der DE 10 2010 042 227 A1 ist ein Verfahren zum elektrischen Aufladen eines elektrischen Energiespeichers mittels einer Ladestation bekannt, wobei ein elektrisches Andocken des elektrischen Energiespeichers an der Ladestation erfasst wird, dadurch gekennzeichnet, dass die Ladestation dem angedockten Energiespeicher eine elektrische Ladeenergie zuführt, wenn zwischen der Ladestation und dem angedockten Energiespeicher ausgetauschte Kommunikationssignale erfasst werden. Die Erfindung betrifft ferner eine Ladestation, einen elektrischen Energiespeicher und eine Mobilvorrichtung.

Aus der EP 2 648 307 A1 ist eine Robotersteuereinheit bekannt, die eine Signalsendeeinheit zum elektrischen Anschluss an ein erstes Andockterminal und zum Senden eines vorbestimmten Detektionssignals enthält, und die eine Signalempfangseinheit zum elektrischen Anschluss an ein zweites Andockterminal enthält. Wenn die Signalempfangseinheit ein vorbestimmtes Rückmeldesignal empfängt, das dem vorbestimmten Detektionssignal entspricht, bestätigt die Robotersteuereinheit, dass der Roboter mit der Andockterminal-Gruppe erfolgreich an eine Dockingstation angedockt hat.

Aus der EP 2 733 860 A1 ist es bekannt, ein elektrisches Fahrzeug über zwei Ladekabel, ein Steuerkabel und ein Massekabel mit einer Ladestation zu verbinden, um dieses mit Leistung zu versorgen und das Laden zu steuern.

Aus der GB 2 555 939 A ist ein elektrisches Stromversorgungssystem mit Wellenformvergleich bekannt, umfassend: einen elektrischen Verbinder; einen Signalsender, der konfiguriert ist, um ein elektrisches Signal mit einer ersten Spannungswellenform an den elektrischen Verbinder zu senden: ein Spannungsmessmodul, das konfiguriert ist, um eine zweite Spannungswellenform an dem elektrischen Verbinder zu messen; und Steuermittel, die einen oder mehrere Prozessoren umfassen, die konfiguriert sind, um die Form der zweiten Spannungswellenform, die durch das Spannungsmessmodul gemessen wird, mit der Form der ersten Spannungswellenform des elektrischen Signals zu vergleichen; und eine Übertragung elektrischer Energie zu und / oder von dem elektrischen Verbinder basierend auf dem Vergleich zu steuern. Das elektrische Signal kann ein Wechselstromsignal sein, das zwei Impulse umfasst, die die gleiche Dauer und die gleiche und entgegengesetzte Amplitude haben können. Das Stromversorgungssystem kann Teil eines tragbaren Gegenstands wie einer Weste sein.

Der Erfindung liegt daher die Aufgabe zugrunde, bei einer Ladestation für einen Verbraucher, insbesondere Roboter einen kritischen Stromfluss durch einen kurzschließenden Fremdkörper zu verhindern und damit eine Brandentstehung auszuschließen.

Diese Aufgabe wird durch eine Ladestation für einen bestimmungsgemäßen Verbraucher, insbesondere mit den Merkmalen des Anspruchs 1, durch eine Anordnung umfassend die Ladestation und den Verbraucher, insbesondere Roboter, mit den Merkmalen des Anspruchs 8 sowie durch ein Verfahren mit den Merkmalen des Anspruchs 9 gelöst. Bevorzugte oder vorteilhafte Ausführungsformen der Erfindung ergeben sich aus den Unteransprüchen, der nachfolgenden Beschreibung sowie den beigefügten Figuren.

Gegenstand der Erfindung ist eine Ladestation, welche für einen bestimmungsgemäßen Verbraucher, insbesondere Roboter geeignet und/oder ausgebildet ist. "Bestimmungsgemäß" ist hierbei und im Folgenden wie folgt zu verstehen: Es wird für die Ladestation davon ausgegangen, dass die Rahmenbedingungen des Verbrauchers bekannt sind. Dies ist möglich, da die Ladestation für einen bestimmten Verbraucher, Verbrauchertyp oder bestimmte Rahmenbedingungen von Verbrauchern ausgelegt ist. Derartige Verbraucher können dann mit der Ladestation interagieren. Ladestation und Verbraucher verhalten sich dabei nach einem "Schlüssel-Schloss-Prinzip", d. h. deren gegenseitige Rahmenbedingungen sind aufeinander abgestimmt. So wird die Ladestation z. B. auf bestimmte interne elektrische Eigenschaften (Verschaltung, Bauteile, ...) des Verbrauchers ausgelegt.

Die Ladestation kann - insbesondere in Verbindung mit einem Roboter - auch als Basisstation bezeichnet werden. Die Ladestation ist insbesondere stationär angeordnet und dient zum Aufladen des Verbrauchers, insbesondere eines Energiespeichers des Verbrauchers. Der Energiespeicher kann als Akku, Batterie, kapazitiver Energiespeicher etc. ausgebildet sein. Daneben kann die Ladestation auch eine Garage für den Verbraucher, insbesondere Roboter bereitstellen. Der Verbraucher ist insbesondere als ein Roboter, besonders bevorzugt als ein Haushaltsroboter und/oder mobiler Roboter und/oder autonomer Roboter ausgebildet. Beispielsweise ist der Roboter als ein Rasenmäherroboter oder als ein Staubsaugerroboter realisiert. Der Roboter kann auch als Flugroboter, insbesondere Drohne ausgebildet sein. Der Verbraucherkann an die Ladestation andocken oder ankoppeln, um aufgeladen zu werden.

Die Ladestation weist eine Ladeschnittstelle auf, welche durch Elektroden (im Folgenden auch "Ladeelektroden" genannt) gebildet ist. Besonders bevorzugt weist die Ladeschnittstelle mindestens oder genau zwei Elektroden auf, wobei die eine Elektrode als ein Pluspol und die andere Elektrode als ein Massepol oder Minuspol ausgebildet ist. Der Verbraucher weist (bestimmungsgemäß, s. o.) eine Gegenschnittstelle auf, welche kompatibel und/oder komplementär zu der Ladeschnittstelle ausgebildet ist. Insbesondere können Ladeschnittstelle und Gegenschnittstelle derart gekoppelt werden, dass ein Ladestrom übertragbar ist. Die Verbindung zwischen der Ladeschnittstelle und der Gegenschnittstelle erfolgt kontaktierend und insbesondere nicht kontaktlos. Die Übertragung des Ladestroms erfolgt somit insbesondere über Kabel, Leiterbahnen und andere metallische Leiter.

Der Verbraucher weist eine Ladeeinrichtung und einen Energiespeicher auf, wobei die Gegenschnittstelle über die Ladeeinrichtung mit dem Energiespeicher verschaltet ist, so dass der Energiespeicher über die Gegenschnittstelle aufladbar ist. Insbesondere kann an die Gegenschnittstelle eine Ladespannung bzw. ein Ladestrom angelegt werden, welcher zum Aufladen des Energiespeichers dient.

Die Ladestation weist eine Versorgungseinrichtung zur Versorgung der Ladeschnittstelle insbesondere mit Energie und/oder mit Ladestrom und/oder Ladespannung, auf. Die Versorgungseinrichtung ist in einen Ladezustand und in einen Nicht-Ladezustand setzbar. In dem Ladezustand wird ein Ladestrom und/oder eine Ladespannung zum Laden des Energiespeichers an der Ladeschnittstelle bereitgestellt. In dem Nicht-Ladezustand ist die Ladeschnittstelle insbesondere von der Versorgungseinrichtung spannungslos gesetzt.

Die Ladestation weist eine Detektionseinrichtung zur Detektion der Ankopplung des Verbrauchers an die Ladeschnittstelle auf. Insbesondere kann die Detektionseinrichtung einen Status "Verbraucherangekoppelt/angedockt" oder "Verbraucher nicht angekoppelt/angedockt" ausgeben. Die Detektionseinrichtung kann als eine digitale Datenverarbeitungseinrichtung, wie zum Beispiel ein Mikroprozessor oder dergleichen ausgebildet sein, alternativ oder ergänzend ist die Detektionseinrichtung als eine analoge Schaltung ausgebildet.

Im Rahmen der Erfindung wird vorgeschlagen, dass die Detektionseinrichtung insbesondere programmtechnisch und/oder schaltungstechnisch, ausgebildet ist, bei einem Nicht-Ladezustand der Versorgungseinrichtung ein Testsignal (Spannung und/oder Strom) an die Ladeschnittstelle anzulegen und in diesem Zusammenhang (also vor und/oder während und/oder nach dem Anlegen des Testsignals) eine elektrische Größe basierend auf der komplexwertigen elektrischen Ausgangsimpedanz der Ladeschnittstelle als Detektionsgröße zur Detektion der Ankopplung des Verbrauchers an die Ladeschnittstelle zu erfassen. Die elektrische Größe ist insbesondere die Spannung zwischen den Elektroden oder der durch wenigstens eine der Elektroden fließende Strom. Die Detektionseinrichtung registriert somit eine elektrische Größe, welche durch die elektrische Ausgangsimpedanz erzeugt oder zumindest beeinflusst wird. Die Ausgangsimpedanz ist diejenige, die an der Ladeschnittstelle bezüglich der Ladestation nach außen, also zur "Verbraucherseite" hin, gesehen wird. Durch Anlegen des Testsignals stellt sich dann - je nach Situation: Verbraucher angekoppelt oder nicht - ein bestimmter Teststrom bzw. Testspannung an der Ladeschnittstelle ein.

Andere Detektionsmethoden identifizieren zum Beispiel Störobjekte, insbesondere metallische Störobjekte, fälschlicherweise als Verbraucher. Dagegen führt die erfindungsgemäße Detektionseinrichtung zu einer Detektion, welche auf den elektrischen Eigenschaften und/oder Impedanz des Energiespeichers und/oder Verbrauchers beruht, die damit eine Verwechslung mit Fremdkörpern, passiven Gegenständen, insbesondere den metallischen Störobjekten, ausschließt. Durch das Anlegen des Testsignals erfolgt ggf. nur ein reduzierter Energieeintrag in ein metallisches Störobjekt so dass eine Brandgefahr basierend auf einen Stromfluss durch ein metallisches Störobjekt reduziert ist. Somit stellt die Erfindung eine sichere Detektion der Ankopplung des Verbrauchers an die Ladeschnittstelle bereit, wobei zugleich eine Brandgefahr reduziert ist.

Besonders vorteilhaft ist, dass die Ladestation ein Nachrüstsystem für bereits bestehende Verbraucher ohne Änderung des Verbrauchers selbst bilden kann, also nur durch Austausch der Ladestation einsetzbar ist. Spezifische Anpassungen an dem Verbraucher sind nicht notwendig.

Es ist auch eine Überlegung der Erfindung, eine Ergänzung bzw. Alternative zu einer passiven Verbraucherdetektion, basierend auf einer Impedanzmessung vorzuschlagen. Eine passive Verbraucherdetektion ist in der am selben Anmeldetag eingereichten Patentanmeldung EP 3 616 976 A1 (Bezugsdokument) "Ladestation für einen Verbraucher, Anordnung umfassend den Verbraucher und die Ladestation sowie Verfahren" beschrieben, auf die hiermit Bezug auch insofern genommen wird. Für die dort offenbarten Merkmale kann auch vorliegend Schutz begehrt werden, diese Merkmale tragen zum technischen Ziel der Erfindung und somit zur Lösung der der anmeldungsgemäßen Erfindung zugrunde liegenden technischen Aufgabe bei, die Merkmale gehören damit implizit zur Beschreibung der in der eingereichten Anmeldung enthaltenen Erfindung und damit zum Offenbarungsgehalt dieser Anmeldung, die Merkmale sind in dem gesamten technischen Informationsgehalt des Bezugsdokuments genau definiert und identifizierbar.

Die grundsätzliche Problematik und Aufgabenstellung ist gegenüber einer passiven Detektionsmethode unverändert und auch der grundsätzliche Aufbau der Lade- oder Basisstation bestehend aus einem Netzteil, das die Ladespannung erzeugt, sowie einem nachgeschalteten Schaltelement, das sie bei Anwesenheit des Verbrauchers auf die Ladekontakte aufschaltet, bleibt erhalten. Das Schaltelement bewirkt die Umschaltung zwischen dem Lade- und dem Nicht-Ladezustand. Das Schaltelement ist Teil bzw. bildet daher auch eine Trenneinrichtung, wie sie weiter unten näher erläutert wird.

Es unterscheidet sich lediglich das jeweils eingesetzte Prinzip der Verbraucherdetektion, also der Methode mit deren Hilfe festgestellt werden kann, ob sich der Verbraucher auf den Ladekontakten befindet oder ein leitender Fremdkörper diese kurzschließt. Bei den in der parallelen Patentanmeldung betrachteten Verfahren handelt es sich dabei um rein passive Verfahren, die auf der Feststellung von Leckströmen durch die Eingangsschutzdiode bzw. der an den Kontaktelektroden des Verbrauchers (auch "Gegenelektroden" genannt) messbaren Akkuspannung basieren. In jedem Fall werden die zu detektierenden Größen direkt oder indirekt durch die Ausgangsspannung des Verbraucherakkus bestimmt.

Der große Vorteil aller passiven Verfahren ist, dass in der Detektionsphase durch sie keinerlei Energieeintrag (seitens der Ladestation) in ein System, das die Ladeelektroden kontaktiert, stattfindet. Insbesondere wird keine Energie an einen die Ladeelektroden kurzschließenden leitenden Fremdkörper abgegeben, so dass dieser selbst im ungünstigsten Fall nicht in Brand geraten kann. Außerdem sind passive Verfahren sehr schnell, da sie auf einfachen Spannungs- oder Strommessungen von Gleichspannungen bzw. Gleichströmen basieren.

Der Nachteil der passiven Verfahren besteht darin, dass sie eben auf einer vorhandenen Akkuspannung des Verbrauchers basieren. Wenn der Verbraucher, insbesondere Roboter selbstständig auf die Station auffährt, wird diese natürlich vorhanden sein, denn der Roboter kann ohne ausreichende Energieversorgung sich selbstverständlich nicht autonom fortbewegen. Die meisten Roboterakkus - namentlich Lithium-Ionen-Akkus - verfügen über ein eigenes Batteriemanagement-System (BMS), das zum Schutz gegen eine schädliche bzw. bei Lithium-Ionen-Akkus sogar gefährliche Tiefentladung bei Unterschreiten einer Schutzschwelle der Akkuspannung, den Akku von der Roboterelektronik elektrisch trennt, so dass kein weiterer Strom aus dem Akku bezogen werden kann. Ein Roboter mit einem durch das BMS abgetrennten Roboterakku kann prinzipbedingt durch die passiven Methoden nicht erkannt werden, wenn z. B. der User den Roboter zum Aufladen manuell auf die Basisstation stellt. Ohne Ladespannung wird der Akku aber nicht mehr vom BMS zugeschaltet.

Demgegenüber sind die hier beschriebenen aktiven Detektionsverfahren durch eine Impedanzmessung langsamer und müssen mit Testspannungen bzw. -strömen (Testsignal) arbeiten, so dass sie auch Energie in einen möglichen Kurzschluss eintragen. Durch entsprechende Auslegung der Schaltung muss dann aber sichergestellt werden, dass dieser Energieeintrag so gering ist, dass er nicht zu einer Brandentstehung führen kann. Der Energieeintrag durch die Ladestation ermöglicht es nun aber einen Verbraucher völlig unabhängig vom Ladezustand des Akkus zu erkennen und danach per aufgeschalteter Ladespannung zu laden.

Das Detektionsverfahren hat die Aufgabe eindeutig, sicher und (bei selbstständig andockendem Roboter) auch hinreichend schnell den Verbraucher zu erkennen und ihn insbesondere von einem Kurzschluss über den Ladeelektroden unterscheiden zu können.

Das dabei verwendete Charakteristikum ist die (komplexe bzw. komplexwertige) Impedanz des Verbrauchers bzw. eines Kurzschlusses. Ein Kurzschluss in Form eines metallischen Fremdkörpers, der die Ladeelektroden überbrückt, weist fast ausschließlich eine rein ohmsche Impedanz auf. Es sind lediglich sehr geringe Anteile induktiver (im nH-Bereich) bzw. kapazitiver (nur im pF-Bereich) Natur möglich.

Demgegenüber weisen die meisten Verbraucher zur Unterdrückung von Prelleffekten und von HF-Störungen beim Auffahren auf die Ladeelektroden einen Kondensator (meist in der Größenordnung von 10 - 100 nF) unmittelbar über die Kontaktelektroden geschaltet auf. Darüber hinaus befindet sich unmittelbar am Spannungsausgang des Akkus zumeist noch ein wesentlich größerer Pufferkondensator (meist in der Größenordnung 100 uF), der aber in Abhängigkeit von der Verbraucherschaltung u. U. an den Gegenelektroden des Verbrauchers festzustellen ist. Stellt man also über den Ladeelektroden der Ladestation eine Kapazität größer 10 nF fest so kann man davon ausgehen, dass nicht ein metallischer Fremdkörper die Ladeelektroden kurzschließt, sondern dass der Verbraucher mit seinen Gegenelektroden die Ladekontakte kontaktiert.

Zur Messung der Impedanz stehen sehr viele verschiede Verfahren zur Verfügung. Ganz grundsätzlich kann man sie danach unterschieden, ob sie versuchen die Impedanz eher im Zeit- oder im Frequenzbereich zu messen. Bei Messungen im Zeitbereich (also über der Zeit) arbeitet man mit impulsförmiger Stimulation und misst z. B. die Sprung- oder Impulsantwort, bei Messungen im Frequenzbereich stimuliert man dagegen mit Wechselspannungen unterschiedlicher Frequenz oder einem anderen Signal mit einem definierten Frequenzspektrum und versucht den Frequenzgang bzw. die Veränderung des Spektrums ganz oder teilweise zu ermitteln.

Die Erfindung bezieht sich insbesondere auf ein System bestehend aus der Ladestation/Basisstation und einem mobilen autonomen System, dem Roboter. Der Begriff "autonom" ist hier wichtig, denn das Gesamtsystem ist damit nicht überwacht. Es handelt sich um einen unbeaufsichtigten Betrieb, an den höhere Sicherheitsanforderungen zu stellen sind als beispielsweise bei der Benutzung eines Handstaubsaugers, bei dem ein Benutzer im Betrieb jeweils eingreifen kann, wenn er ein Sicherheitsproblem entdeckt.

Die Problemstellung, die die Erfindung für einen Roboter löst, kann jedoch in ähnlicher Form auch für manuell betriebene Reinigungsgeräte auftreten. Konkret handelt es sich dabei um akkubetriebene Handgeräte. Bei der Aufladung mit einem Steckernetzteil, das über ein Kabel mit angeschlossenem Steckverbinder mit dem Gegenstück im Staubsauger verbunden wird, stellt sich das Problem nicht, da es keine großflächigen offenliegenden Elektroden gibt. Ein Verbraucher bzw. Gerät jedoch, z. B. ein Feuchtsauger, das über eine Art auf dem Boden stehende Ladestation verfügt, auf dem das Gerät abgestellt und dort aufgeladen werden kann, weist jedoch ähnliche Probleme auf. Mechanisch wird das Gerät z. B. an der Ladestation eingehängt und über relativ große offenliegende Elektroden (nicht am Boden aber seitlich in Bodennahe) mit Ladestrom versorgt. Wann immer das Gerät von der Ladestation entfernt wird, z. B. um den Raum zu reinigen, liegen die Ladeelektroden der Ladestation offen und es besteht im Prinzip die gleiche Gefahr wie beim Roboter-System. Wenn das Gerät entfernt ist, z. B. der Benutzer einen anderen Raum saugt oder gar den Staubsauger noch geladen in einem anderen Raum unbenutzt abstellt (nicht so selten in mehrgeschossigen Wohnungen) befindet sich die Ladestation in einem unbeaufsichtigten Betrieb - also exakt der gleiche Fall wie beim Roboter-System. Dieses Sicherheitsproblem kann in exakt gleicher Weise wie beim Roboter durch die Erfindung gelöst werden.

Bei einer bevorzugten Ausgestaltung der Erfindung enthält die Detektionsgröße bzw. die elektrische Größe, den Imaginärteil der Ausgangsimpedanz, also deren kapazitiven oder induktiven Anteil. Insbesondere wird ausschließlich dieser Anteil verwendet. Insbesondere ist dies die elektrische Ausgangskapazität. Optional ist in der Detektionsgröße zusätzlich auch der Realteil der Ausgangsimpedanz berücksichtigt, insbesondere der ohmsche Ausgangswiderstand zwischen den Elektroden. "Ausgang" ist wieder wie oben zu verstehen. Die elektrische Größe ist also eine beliebige komplexwertige Impedanz mit reaktivem und/oder kapazitivem Anteil. Ersatzschaltbilder sind z. B. die Reihen- oder Parallelschaltung von Kondensator und Widerstand. Es ist davon auszugehen, dass sich derartige Impedanzen von Verbraucher und Fremdkörpern in der Regel unterscheiden und so auch eine wirksame Unterscheidung zwischen Andocken/Abdocken des Verbrauchers und eines Fremdkörpers getroffen werden kann.

Alternativ oder ergänzend wird vorgeschlagen, dass die Ladestation einen Belastungswiderstand aufweist, welcher schaltungstechnisch zwischen den Elektroden der Ladeschnittstelle angeordnet ist. Dieser kann z. B. Entladungsvorgänge im Verbraucher auslösen, die durch Anlegen des Testsignals initiiert werden. So können dynamische Vorgänge bzw. Impedanzverläufe ausgelöst werden, die dann wieder unterschiedliche und damit unterscheidbare Charakteristiken für an-/abgedockte Verbraucher und Störobjekte aufweisen. Vorzugsweise ist der Belastungswiderstand mindestens hochohmig ausgebildet. Unter hochohmig wird insbesondere ein Widerstandswert verstanden, welcher so bemessen ist, dass mindestens 95 %, vorzugsweise mindestens 98 % der an den Elektroden der Ladeschnittstelle anliegenden Restspeicherspannung abfällt. Beispielsweise kann der Belastungswiderstand größer als 1 MOhm, vorzugsweise größer als 5 MOhm und insbesondere größer als 9 MOhm ausgebildet sein.

Der Belastungswiderstand ist vorzugsweise so bemessen, dass weniger als 95 %, vorzugsweise weniger als 90 % und insbesondere weniger als 85 % der an den Elektroden der Ladeschnittstelle anliegenden Restspeicherspannung an dem Belastungswiderstand abfällt. Im Gegensatz zu der zuvor beschriebenen Ausgestaltung wird durch die Verwendung eines mäßig hochohmigen Belastungswiderstands erreicht, dass Störeinflüsse, die bei sehr hochohmigen Belastungswiderständen durch eine Antennenwirkung der Belastungswiderstände bei der Spannungsmessung entstehen können, eliminiert oder zumindest verringert sind. Nachdem derartige Störeinflüsse insbesondere durch elektrostatische Auf- und Entladungen entstehen können, ergibt sich durch die alternative Ausgestaltung eine höhere Störsicherheit.

Bei einer alternativen Ausgestaltung der Erfindung ist vorgesehen, dass die Ladeeinrichtung des Verbrauchers eine Sperrdiode aufweist. Die Sperrdiode kann auch als Eingangsschutzdiode bezeichnet werden. Diese Diode dient zum einen als Verpolungsschutz, falls der Verbraucher falsch auf die Elektroden aufgesetzt werden sollte, und hat zum anderen die Aufgabe, einen eventuellen Kurzschluss zu verhindern, falls die Gegenelektroden des Verbrauchers durch ein Metallteil kurzgeschlossen werden, beispielsweise, weil ein Verbraucher mit seitlich angebrachten Gegenelektroden ein metallisches Stuhlbein mit beiden Elektroden berührt. Ferner dient die Sperrdiode dazu, eine Entladung des Verbrauchers über die Ladestation zu verhindern, falls sich der Verbraucher mit aufgeladenem Energiespeicher auf der Ladestation befindet, die Ladestation aber aktuell keine Netzspannung beispielsweise aufgrund eines Stromausfalls erhält. Bei dieser Diode handelt es sich vorzugsweise um eine Leistungsdiode, die den mehrere Ampere betragenden Ladestrom des Verbrauchers weitgehend verlustlos durchschalten können muss.

Bei einer bevorzugten Weiterbildung der Erfindung weist die Ladestation eine Steuereinrichtung auf. Die Steuereinrichtung kann als eine separate Einrichtung ausgebildet sein oder einen integralen Bestandteil der Detektionseinrichtung bilden. Für den Fall, dass die Steuereinrichtung als eine separate Einrichtung ausgebildet ist, kann diese als digitale Verarbeitungseinrichtung und/oder schaltungstechnische Verarbeitungseinrichtung ausgebildet sein. Die Steuereinrichtung ist insbesondere programmtechnisch und/oder schaltungstechnisch ausgebildet, auf Basis der Detektionsgröße die Versorgungseinrichtung zwischen dem Ladezustand und dem Nicht-Ladezustand umzuschalten. Hierzu kann die Steuereinrichtung die Detektionsgröße und/oder einen auf der Detektionsgröße basierenden Status wie z. B. "Verbraucher angekoppelt/angedockt" oder "Verbraucher nicht angekoppelt/angedockt" erhalten. Insbesondere ist die Steuereinrichtung ausgebildet, bei dem Status "Verbraucher angekoppelt/angedockt" oder einer entsprechenden Detektionsgröße die Versorgungseinrichtung von dem Nicht-Ladezustand in den Ladezustand umzuschalten.

Bei einer bevorzugten konstruktiven Anpassung der Erfindung weist die Ladestation eine Trenneinrichtung zur Unterbrechung des Ladestroms und/oder der Ladespannung auf. Die Trenneinrichtung ist insbesondere zum Abkoppeln der Ladeschnittstelle, insbesondere mindestens einer Elektrode der Ladeschnittstelle, ausgebildet. Beispielsweise ist die Trenneinrichtung als ein Schalter (das o.g. Schaltelement), z. B. als ein Relais oder MOS-FET, ausgebildet. Die Steuereinrichtungen ist ausgebildet, die Trenneinrichtung anzusteuern, um die Versorgungseinrichtung zwischen dem Ladezustand und dem Nicht-Ladezustand umzuschalten.

Es ist bevorzugt, dass die Ladestation eine Ladestromprüfeinrichtung zur Erfassung des Ladestroms aufweist. Bei der Detektion der Detektionsgröße muss berücksichtigt werden, dass es im Ladezustand zu einem selbsthaltenden Effekt kommt, sobald der Verbraucher einmal erkannt und die Ladespannung und/oder der Ladestrom aufgeschaltet wurde. Je nach gewähltem Verfahren, wäre auch bei angelegter Ladespannung eine Impedanzmessung möglich (z. B. durch Messungen im Frequenzbereich) aber technisch schwierig und aufwendig. Durch die Ladestromprüfeinrichtung wird der Ladestrom überwacht, so dass erkannt werden kann, wenn der Verbraucher den Ladevorgang abbricht oder beendet. In diesem Fall wird der Ladestrom zusammenbrechen und/oder auf 0 gehen. Ein fehlender Ladestrom ist zwar eine notwendige Bedingung für das Abdocken des Verbrauchers, aber keine hinreichende Bedingung. Es kann nämlich durchaus der Fall auftreten, dass der Verbraucher mit teilentladenem Energiespeicher auf die Ladestation auffährt, dort den Energiespeicher voll auflädt und danach keinen weiteren Ladestrom aufnimmt aber dennoch die Ladestation nicht verlässt, da seine Arbeit beendet ist und er nun in Bereitschaftsstellung auf der Ladestation verbleibt. Ob in diesem Bereitschaftszustand ein kleiner Versorgungsstrom für den aktuellen Verbrauch der Verbraucherelektronik von der Ladestation oder aus dem Energiespeicher aufgenommen wird, hängt von der Bauart des Verbrauchers ab. Optional erfolgt die Stromaufnahme im Bereitschaftsbetrieb beispielsweise ausschließlich aus dem Energiespeicher. Optional könnte man auch die Ladespannung immer wieder kurzzeitig unterbrechen und während der Unterbrechung eine Verbraucherdetektion wie zuvor beschrieben durchführen. Ständige Unterbrechungen während eines Ladevorgangs würden aber die gesamte Ladezeit verlängern und die ständigen Unterbrechungen wären auch nicht vorteilhaft im Hinblick auf die Lebensdauer des Energiespeichers. Daher wird insbesondere zusätzlich der Ladestrom geprüft (Ein fehlender Ladestrom ist ja ein notwendiges Kriterium für das Abdocken des Verbrauchers) und es erfolgt keine neue Verbraucherdetektion solange nach der Erstdetektion des Verbrauchers der Ladestrom fließt.

Es ist bevorzugt vorgesehen, dass die Steuereinrichtung die Versorgungseinrichtung ansteuert von dem Ladezustand in den Nicht-Ladezustand zu gehen, sobald über den Ladestrom und/oder die Ladestromprüfeinrichtung erkannt wird, dass der Verbraucher den Status "Verbraucher nicht ladend" eingenommen hat. Insbesondere ist die Detektionseinrichtung programmtechnisch und/oder schaltungstechnisch ausgebildet, bei einem Ladezustand der Versorgungseinrichtung eine weitere elektrische Größe basierend auf dem Ladestrom als weitere Detektionsgröße zur Detektion des Ladens des Verbrauchers an der Ladeschnittstelle zu erfassen.

Gemäß der Erfindung enthält die Ladestation einen Testsignalgenerator, insbesondere eine Spannungsquelle (oder auch Stromquelle), zum Anlegen einer impulsförmigen Quellspannung (oder zum Einprägen eines bestimmten Stromsignals) in Form des Testsignals zwischen den Elektroden vor und/oder während der Erfassung der elektrischen Größe, und die Detektionseinrichtung ist dazu ausgebildet die Erfassung der elektrischen Größe im Zeitbereich durchzuführen. Als Testsignal wird ein Spannungsimpuls oder ein Spannungssprung vorgegeben. Von der Detektionseinrichtung wird dann die Impuls-/Sprungantwort gemessen und ausgewertet. Insbesondere erfolgt also ein pulsförmiges Anlegen einer Konstantspannungsquelle. Der Testsignalgenerator kann eine eigenständige Signalquelle sein, er kann auch implizit durch andere Komponenten wie z. B. die Versorgungseinrichtung und ggf. die Trenneinrichtung gebildet werden. Der Impuls bzw. Sprung der Spannung kann auch dadurch erzeugt werden, dass der Ladezustand bzw. das Laden des angeschlossenen Verbrauchers unterbrochen wird, um die Impedanzmessung durchzuführen. Dabei wird also die Ladespannung abgeschaltet, was zu einem insbesondere abfallenden Spannungssprung führt. Die Sprungantwort wird dann gemessen und ausgewertet. Die Unterbrechung ist bzw. führt also damit zur Erzeugung des Spannungspulses (der abfallenden Flanke des Pulses).

Es ist dabei eine Überlegung der Erfindung, dass eine Impedanzmessung im Zeitbereich durchgeführt wird. Der Hardwareaufbau kann hierbei sehr dem Aufbau für ein passives Messverfahren ähneln. Wenn man das Verfahren mit einem Mikrokontroller realisiert, kann man sogar eine identische Hardware benutzen und muss nur die jeweilige Steuersoftware anpassen. Auf die damit verbundenen Vorteile wird an späterer Stelle noch eingegangen werden.

Beispielsweise wird periodisch die Impulsantwort des Systems an den Ladeelektroden gemessen. Dazu wird periodisch ein kurzer Stimulus-/Stimulationsimpuls (Dauer tp z. B. 0,2 ms) als Testsignal auf die Ladeelektroden gegeben. Das geschieht z. B., in dem ein Schaltelement kurzzeitig durchgesteuert wird, das die Versorgungseinrichtung im Ladezustand an die Elektroden durchschaltet. Als Schaltelement ist dafür ein Relais weniger geeignet und es sollte vorzugsweise ein MOSFET-Transistor Anwendung finden. Wenn die Steuerspannung am Gate gesteuert von einer Kontrolleinheit High ist, wird der MOSFET durchgesteuert und die Ladespannung wird kurzzeitig an die Ladeelektroden angelegt. Dann kann man dann also Ladespannung während der Impulsdauer tp des Stimulationsimpulses messen. Bei einem die Elektroden kurzschließenden Fremdkörper wird der Signalverlauf ähnlich sein, allerdings ist die Amplitude des Signals meist deutlich geringer bis hin zu fast Null bei einem satten (sehr niederohmigen) Kurzschluss.

Ist dagegen der Verbraucher angedockt, so macht sich ein (bekanntermaßen im bestimmungsgemäßen Verbraucher vorhandener) Kondensator an bzw. zwischen den Gegenelektroden des Verbrauchers bemerkbar. In diesem Fall wird die Spannung bei Aufschaltung des Stimulusimpulses wegen der Aufladung des Kondensators etwas länger ansteigen und dann für den Rest der Impulsdauer tp konstant bleiben. Nach dem Ende des Stimulusimpulses wird der Kondensator langsam über einen Innenwiderstand in der Ladestation zwischen den Elektroden, z. B. den Belastungswiderstand, entladen. Damit ergibt sich als Spanungsverlauf die typische exponentielle Entladekurve einer RC-Kombination die asymptotisch gegen Null läuft (RC-Lade-/Entladekurve). Indem man nun z. B. die Spannung an den Elektroden mit einer Zeitverzögerung Δt (z. B. 5 ms) nach dem Ende des Stimulationsimpulses, also zum Zeitpunkt tM misst, hat man ein sehr eindeutiges Indiz, um freie Ladeelektroden sowie auch einen Kurzschluss von einem angedockten Verbraucher unterscheiden zu können. Misst man zum Zeitpunkt tM einen signifikanten Spannungspegel, so muss an den Elektroden ein kapazitives Element, der Verbraucher mit seiner Eingangsschaltung, anliegen, da ein Kurzschluss eben grundsätzlich keine signifikante kapazitive Komponente aufweist.

Zur Verbesserung der Störempfindlichkeit empfiehlt es sich optional, nicht nur eine Messabtastung durchzuführen, sondern mehrere und über diese zu mitteln oder gar die Abstiegsflanke der Entladekurven in die Auswertung mit einzubeziehen, also zu überprüfen, dass aufeinanderfolgende Messungen jeweils monoton fallende Werte aufweisen müssen. Übrigens ist optional der Belastungswiderstand auch nicht unbedingt erforderlich, da eine Entladung der bekannten internen Kapazität des Verbrauchers für die Messung nicht notwendigerweise erforderlich ist. Ohne Belastungswiderstand erfolgt die Messung aber sehr hochohmig und ist dadurch empfindlich gegen elektrostatische Aufladung wie sie gerade in Bodennähe speziell bei Kunstfaserteppichen leicht auftreten können.

Wie oft der Stimulusimpuls erzeugt werden muss bzw. sollte, hängt davon ab, wie schnell eine Detektion eines Verbrauchers erfolgen soll. Falls der Verbraucher selbstständig auf die Station auffährt, muss die Erkennung schnell (z. B. in weniger als 100 ms) erfolgen, damit über das Schaltelement die Ladespannung noch rechtzeitig aufgeschaltet wird (Übergang von Nicht- in den Ladezustand), bevor der Verbraucher den Kontakt mit den Ladeelektroden verliert. In diesem Fall müssen die Stimulusimpulse in kurzem Abstand (z. B. 30 ms) auf die Ladeelektroden gegeben werden.

Muss dagegen nur das Aufsetzen des Verbrauchers durch den Benutzer erkannt werden, genügt ein Abstand der Stimulusimpulse im Sekundenbereich. Auf der anderen Seite bestimmen das Produkt aus der Zahl der Impulse pro Sekunde und der Impulsdauer tp die pro Sekunde in einen eventuellen Kurzschluss eingebrachte Energie. Sie sollte aus Sicherheitsgründen zur Verringerung einer Brandgefahr möglichst gering sein.

Wie bei passiven Verfahren tritt auch vorliegend ein "selbsthaltender Effekt" auf: Sobald einmal der Verbraucher beim Andocken erkannt und die Ladespannung über das Schaltelement aufgeschaltet wurde, lässt sich an den Elektroden nur noch die Ladespannung feststellen, die Impedanzmessung also nicht mehr durchführen. Daher ist auch hier ebenso wie bei den passiven Verfahren eine Abdockerkennung erforderlich. Gemäß der Erfindung erreicht man dies z. B. ebenso wie bei den passiven Verfahren dadurch, dass von Zeit zu Zeit (z. B. alle paar Sekunden) die Ladespannung unterbrochen wird und während der Unterbrechung dann erneut das Detektionsverfahren durchgeführt wird. Insbesondere ist dabei sogar der Stimulusimpuls während der Unterbrechung überflüssig, da unmittelbar vor der Unterbrechung noch die Ladespannung anlag und den Kondensator im Verbraucher auflud. Wie bei den passiven Verfahren kann auch hier sehr vorteilhaft der Ladestrom gemessen und überwacht werden, um eine technisch in Bezug auf den Akku nachteilige Unterbrechung des Ladevorgangs zu verhindern. Die entsprechenden Überlegungen bei den passiven Verfahren können hier analog übernommen werden.

Bei einer bevorzugten Ausgestaltung der Erfindung ist die Detektionseinrichtung daher dazu ausgebildet, eine Detektion des Verbrauchers nur festzustellen, wenn die elektrische Größe im Zeitbereich einer RC-Lade- und/oder Entladekurve zwischen den Elektroden entspricht, die mit der Eingangskapazität des bestimmungsgemäß angeschlossenen Verbrauchers im Einklang steht, d. h. entsprechend zu erwartende, vom bestimmungsgemäßen Verbraucher her bekannte bzw. dimensionierte Werte, ermittelt werden. Insbesondere werden dabei ein oder zwei oder mehrere Messpunkte, insbesondere ein kompletter Kurvenverlauf, insbesondere eine Flankensteilheit und/oder Flankenform des Verlaufs der elektrischen Größe, z. B. der Spannung zwischen den Elektroden aufgenommen und ausgewertet. Der typische RC-Verlauf geht dabei exponentiell asymptotisch zu Null bei Wegnahme des Testsignals.

Im Rahmen der Ermittlung wird insbesondere die Ausgangskapazität an den Elektroden und damit die Eingangskapazität des Verbrauchers im angedockten Zustand ermittelt. Detektiert wird der Verbraucher, wenn eine Kapazität von mindestens 5, 8, 10, 15 oder 20 nF erkannt wurde, ansonsten ergibt sich eine Nicht-Detektion, also im Ergebnis, dass aktuell kein bestimmungsgemäßer Verbraucher angeschlossen ist. Die Detektion wird also insbesondere dadurch festgestellt ist, dass zu einem vorgebbaren Zeitpunkt nach Abschalten des Testsignals mindestens eine vorgebbare Restspannung zwischen den Elektroden anliegt. Die Werte sind dabei auf die elektrischen Kenngrößen der Ladestation und des bestimmungsgemäßen Verbrauchers dimensioniert.

Bei einer bevorzugten Ausgestaltung der Erfindung enthält die Ladestation einen Testsignalgenerator, insbesondere eine Spannungsquelle zum Anlegen eines Testsignals zwischen den Elektroden vor und/oder während der Erfassung der elektrischen Größe, und die Detektionseinrichtung ist dazu ausgebildet, die Erfassung der elektrischen Größe im Frequenzbereich durchzuführen. Es wird also ein Testsignal an die Elektroden anlegt und dort eine elektrische Größe registriert und dann das Spektrum des registrierten Signals ganz oder teilweise betrachtet und daraus Rückschlüsse auf die Anwesenheit des Verbrauchers, insbesondere Roboters gezogen. Im einfachsten Fall ist das ein einfaches Sinussignal einer Frequenz, die verändert wird, oder z. B. ein Mehrtonsignal (eine Überlagerung mehrerer Sinusschwingungen unterschiedlicher Frequenz). Aber es kann auch ein nicht periodisches Signal verwendet werden. Ein typisches Beispiel wäre dazu ein Rauschsignal. Dies ist nicht nur theoretisch interessant, sondern ganz praktisch von Belang. Es lassen sich sehr einfach mit einem Mikrokontroller Pseudo-Rausch-Signale (pn-Folgen) erzeugen. Dann wird einfach das Signal an den Elektroden registriert und per FFT in den Frequenzbereich transformiert. Dort kann dann z. B. beobachtet werden, ob das Spektrum eines eigentlich weißen Rauschens mit zunehmender Frequenz bedämpft wird (durch einen Kondensator).

Mit anderen Worten wird also eine Wechselspannung, z. B. unterschiedlicher Frequenzen angelegt und der Frequenzgang ganz oder teilweise der Gesamtanordnung (Ladestation und ggf. Verbraucher und/oder Fremdkörper) bestimmt und ausgewertet.

Es ist dabei eine Überlegung der Erfindung, dass neben der Messung im Zeitbereich auch eine Messung im Frequenzbereich möglich ist. Man misst dann also nicht die Impuls- oder Sprungantwort des an den Ladeelektroden befindlichen Systems, sondern z. B. den Frequenzverlauf. Ein Beispiel soll im Folgenden dargestellt werden. Im Unterschied zu den passiven Verfahren und zur Messung im Zeitbereich ist hier - falls vorhanden - ein Spannungsmesseingang zum bzw. am Mikrokontroller überflüssig. Dafür verfügt der Mikrokontroller zusätzlich über einen Impulseingang, der mit einem Frequenzzähler verbunden ist. Im allgemeinen Fall ist jedenfalls ein Frequenzzähler vorzusehen.

Der Frequenzzähler bzw. eine zugehörige Schaltung ist z. B. eine Oszillatorschaltung, von der ein rechteckförmiges Ausgangssignal abgeleitet wird Kern ist ein durch einen Kondensator und die Spule gebildeter Parallelschwingkreis. Der Wert des Kondensators sollte in der Größenordnung der erwarteten Verbraucherkapazität liegen (also z. B. bei 33 nF) und die Spule sollte dann so gewählt werden, dass die Resonanzfrequenz des Schwingkreises zwischen 30 kHz und 500 kHz liegt. Niedrigere Frequenzen sind ungünstig, weil sich dadurch lange Einschwingzeiten ergeben, höhere können zu Problemen mit parasitären Elementen führen und überdies unerwünschte hochfrequente Störungen hervorrufen. Durch einen am Schwingkreis angeschlossenen Komparator wird der Schwingkreis über Rückkopplungswiderstände zu einer Oszillation bei der Resonanzfrequenz angeregt. Es findet zum Beispiel ein Komparator mit komplementären Ausgängen Verwendung. Solche Komparator-ICs sind dem Fachmann beispielsweise als IC LT1713/LT1714 von Linear Technology bekannt. Eine am Ausgang des (ersten) Komparators nachgeschaltete (zweite) Komparatorstufe dient nur dazu, das Oszillatorsignal in ein sauberes Rechtecksignal umzuwandeln, das dann dem Frequenzzähler zugeführt werden kann. Der Referenzpegel für diesen (zweiten) Komparator wird über Widerstände bzw. einen ohmschen Spannungsteiler erzeugt. Über die Kopplungskondensatoren wird der Schwingkreis mit den Elektroden verbunden. Insbesondere liegen also die Ladeelektroden dadurch wechselstrommäßig parallel zum Schwingkreis, während die Kopplungskondensatoren zugleich für eine galvanische Trennung sorgen. Die Kapazitätswerte der Kopplungskondensatoren sollten groß gegen den Wert des Kondensators des Schwingkreises sein, also in diesem Beispiel 2,2 µF betragen. Dafür kommen vorzugsweise unipolare Keramikkondensatoren in Frage.

Die Kapazitätsmessung selbst kann nur bei offenem Schaltelement (Nicht-Ladezustand) erfolgen, bei geschlossenem Schaltelement würde die Schaltung nämlich primär einen sehr großen Glättungskondensator der Ladespannungsquelle "sehen" und den zusätzlichen Beitrag der Verbraucherkapazität (Eingangskapazität) nicht erfassen können.

Man könnte den großen Glättungskondensator zwar mittels einer Drossel davon entkoppeln, doch wäre das im angegebenen Frequenzbereich sehr aufwändig. Damit ergibt sich auch bei diesem Verfahren ganz automatisch ein "selbsthaltender Effekt" wie schon zuvor bei der Zeitbereichsmessung beschrieben. Nur stört diesmal nicht die Ladespannung selbst, sondern eben der Glättungskondensator.

Die Frequenzzählung kann einfach durch den steuernden Mikrokontroller selbst durchgeführt werden. Dazu wird der Ausgang der o. g. (zweiten) Komparatorstufe mit einem Impulseingang des Mikrokontrollers verbunden, der intern mit einer Zählstufe verbunden ist. Setzt man den Zähler zunächst zurück und lässt ihn dann für eine vordefinierte Zeit laufen, so wird er alle Impulse am Eingang des Mikrokontrollers registrieren und nach der vordefinierten Zeit ist der Zählerstand proportional zur Oszillationsfrequenz des Schwingkreises.

Bei freien Ladeelektroden wird der Schwingkreis auf seiner Resonanzfrequenz schwingen. Die beiden Koppelkondensatoren zum Schwingkreis hin haben de facto keinen Einfluss, da die parasitäre Kapazität zwischen den Ladeelektroden allenfalls wenige pF betragen wird. Hat aber der Verbraucher angedockt, liegt dessen Eingangskapazität in Reihe mit den beiden Koppelkondensatoren parallel zum Schwingkreiskondensator. Da die Kapazitätswerte der Koppelkondensatoren wesentlich größer als die Eingangskapazität des Verbrauchers sind, wird dessen Wert die Serienschaltung der drei Kondensatoren dominieren. Folglich liegt bei angedocktem Verbraucher de facto dessen Eingangskapazität parallel zur Schwingkreiskapazität. Damit wird die Oszillationsfrequenz deutlich aber nicht drastisch reduziert. Die Reduktion der Frequenz kann einfach mit Hilfe des angeschlossenen Frequenzzählers ausgewertet werden.

Im Falle eines die Ladeelektroden kurzschließenden metallischen Fremdkörpers liegt die Reihenschaltung der beiden Koppelkondensatoren sowie der (sehr geringen) Impedanz des Fremdkörpers parallel zum Schwingkreis. Dies bedeutet, dass eine sehr große Kapazität (im erwähnten Beispiel rund 1 µF) parallel zum Schwingkreiskondensator liegt und dadurch die Oszillationsfrequenz des Schwingkreises drastisch reduziert.

Damit hat man nun ein Merkmal, um einfach - anhand der von der Zählerstufe gemessenen Frequenz - zwischen drei Fällen, nämlich freien Elektroden, einem Kurzschluss über den Ladeelektroden und einem angedockten Verbraucher, zu unterscheiden. Die Steuerung der Trenneinrichtung kann dann ganz analog zu den passiven Verfahren bzw. zur Impedanzmessung im Zeitbereich erfolgen. Auch der "selbsthaltende Effekt" ist zu (ohne Entkopplung durch eine Drossel) berücksichtigen und der Ladestrom sollte auch hier vorteilhafterweise überwacht werden.

Eine weitere Möglichkeit, die mögliche kapazitive Impedanz des Systems an den Ladeelektroden (Luft, kurzschließender Fremdkörper, Verbraucher) festzustellen, besteht darin, galvanisch entkoppelt Wechselspannungssignale geringer Amplitude mit unterschiedlicher Frequenz an die Ladeelektroden einzukoppeln und dann den jeweils fließenden Strom zu messen. Bei angedocktem Verbraucher muss der Stromfluss aufgrund der Verbraucherkapazität (dessen Eingangskapazität) frequenzabhängig sein, bei einem Kurzschluss dagegen nicht. Anstelle der Wechselspannungssignale können auch Rausch- oder Pseudo-Rausch-Signale treten wie z. B. weißes Rauschen mit frequenzunabhängigem Spektrumverlauf.

Bei einer bevorzugten Weiterbildung der Erfindung enthält daher die Ladestation einen LC-Schwingkreis, dessen Kondensator parallel zu den Kontakten geschaltet ist, und einen Frequenzzähler zur Ermittlung der aktuellen Schwingfrequenz des Schwingkreises, und die Detektionseinrichtung ist dazu ausgebildet, eine Detektion des Verbrauchers nur festzustellen, wenn die Schwingfrequenz sich in einem vorgebbaren Wertebereich unterhalb der Resonanzfrequenz des Schwingkreises befindet. Diese Resonanzfrequenz ist die eigentliche Eigenfrequenz des isolierten Schwingkreises, insbesondere ohne Parallelschaltung weiterer Kapazitäten. Der (in Kenntnis der Eigenschaften des zu detektierenden bestimmungsgemäßen Verbrauchers) vorgebbare Wertebereich geht daher - wie oben erläutert - damit einher, dass die bestimmungsgemäße Eingangskapazität des Verbrauchers an der Ladeschnittstelle angeschlossen und damit dem Schwingkreiskondensator parallel geschaltet ist.

Ein weiterer Gegenstand der Erfindung betrifft eine Anordnung, welche die Ladestation, wie diese zuvor beschrieben wurde bzw. nach einem der vorhergehenden Ansprüche sowie den Verbraucher umfasst. Bei einer bevorzugten Weiterbildung der Erfindung weist die Ladeeinrichtung des Verbrauchers die zuvor beschriebene Sperrdiode auf, wobei die Sperrdiode schaltungstechnisch zwischen der Gegenschnittstelle und dem Energiespeicher angeordnet ist.

In einer bevorzugten Ausführungsform ist der Verbraucher also ein Roboter. Für Roboter ist die Erfindung besonders geeignet, z. B. wegen der höheren Verschleppungsgefahr von kurzschließenden Gegenständen im Vergleich zu anderen Verbrauchern.

Ein weiterer Gegenstand der Erfindung betrifft ein Verfahren zur Detektion des Verbrauchers durch die Ladestation, wie dieses sinngemäß zuvor beschrieben wurde bzw. nach einem der vorhergehenden Ansprüche. Insbesondere ist die Ladestation dabei Teil der erfindungsgemäßen Anordnung.

Das Verfahren umfasst einen Schritt zur Detektion der Ankopplung des Verbrauchers an die Ladeschnittstelle, wobei bei einem Nicht-Ladezustand der Versorgungseinrichtung ein Testsignal an die Ladeschnittstelle angelegt wird und in diesem Zusammenhang elektrische Größe basierend auf der elektrischen Ausgangsimpedanz der Ladeschnittstelle als Detektionsgröße zur Detektion der Ankopplung des Verbrauchers an die Ladeschnittstelle erfasst wird, wie dies zuvor beschrieben wurde. Vorzugsweise wird als elektrische Größe die Spannung zwischen den Elektroden oder der durch wenigstens eine der Elektroden fließende Stromverwendet. Soweit von der Detektionseinrichtung die Detektionsgröße erfasst wurde und durch die Detektionseinrichtung und/oder die Steuereinrichtung ausgewertet wurde und der Verbraucher erkannt wurde, wird die Versorgungseinrichtung vom Nicht-Ladezustand in den Ladezustand gesetzt.

Bei einer bevorzugten Weiterbildung der Erfindung wird der Ladestrom durch die Ladestromprüfeinrichtung insbesondere zyklisch und/oder regelmäßig erfasst, wobei beispielsweise alle 5 Sekunden eine Messung durchgeführt wird. Sofern der Ladestrom positiv detektiert ist, wird der Ladevorgang fortgesetzt. Für den Fall, dass der Ladestrom kleiner als ein vorgebbarer Grenzwert für eine vorgebbare Dauer ist, wird von der Steuereinrichtung und/oder der Detektionseinrichtung darauf geschlossen, dass der Ladevorgang beendet ist oder der Verbraucher von der Ladestation abgekoppelt oder abgedockt ist. Vorzugsweise wird in diesem Fall die Versorgungseinrichtung auf Nicht-Ladezustand gesetzt und es wird wahlweise ein Testsignal an die Ladeschnittstelle angelegt und eine Andockerkennung über die elektrische Größe basierend auf der elektrischen Ausgangsimpedanz der Ladeschnittstelle als Detektionsgröße zur Detektion der Ankopplung des Verbrauchers an die Ladeschnittstelle durchgeführt.

Bei einer bevorzugten Ausgestaltung der Erfindung wird das erfindungsgemäße Verfahren als aktives Verfahren in einer Unterbrechungspause eines wie oben genannten passiven Verfahrens zur Detektion des Verbrauchers durchgeführt, bei dem unter anderem beim Nicht-Ladezustand der Versorgungseinrichtung kein Testsignal an die Ladeschnittstelle angelegt wird. Insbesondere wird das passive Verfahren zyklisch vergleichsweise häufig, z. B. alle ms durchgeführt, das aktive erfindungsgemäße Verfahren dagegen vergleichsweise selten zyklisch, z. B. alle 3 s.

Oben wurde schon erwähnt, dass man die Impedanzmessung im Zeitbereich mit der gleichen Hardware durchführen kann wie bei den genannten passiven Verfahren, wenn man die Steuerung und Auswertung mit Hilfe eines Mikrokontrollers durchführen lässt. Daher lassen sich auch beide Verfahren sinnvoll kombinieren. Man hat dann den Vorteil des recht schnellen und sicheren passiven Verfahrens zur Erkennung des autonomen Andockens des Verbrauchers, kann aber gleichwohl, dann allerdings mit deutlich reduzierter Geschwindigkeit, mittels der Impedanzmessung im Zeitbereich auch einen Verbraucher mit vom BMS abgeschaltetem Akku, der vom Benutzer auf die Lade- /Basisstation gestellt wird, erkennen und aufladen. Dazu wird während der Andockerkennung kontinuierlich jede Millisekunde eine passive Messung durchgeführt. Alle paar Sekunden (im Beispiel alle 3 s) wird die passive Messung kurz unterbrochen und ein Stimulusimpuls aufgeschaltet und wie zuvor beschrieben kurz die Impulsantwort nach der Zeit Δt gemessen. Falls dabei keine signifikante Kapazität festgestellt wird, erfolgt wieder die passive Messung. Die Kombination bietet gegenüber der reinen Impedanzmessung den Vorteil des deutlich verringerten Energieeintrags in einen möglichen Kurzschluss, da nun nur noch alle paar Sekunden statt z. B. mit 30 Hz eine aktive Messung erfolgt.

Das beschriebene passive Verfahren funktioniert offensichtlich dann und nur dann, wenn der Energiespeicher dem Verbraucher eine Versorgungsspannung zur Verfügung stellen kann. Es versagt daher, wenn der Energiespeicher zum Schutz gegen Tiefentladung seine Ausgangsspannung abgeschaltet hat. Speziell Lithium-Ionen-Akkus als Energiespeicher weisen aus Sicherheitsgründen ein eigenes Batteriemanagement-System auf, das die Verbindung des Akkus zur Umgebung trennt, wenn die Akkuspannung einen Sicherheitslevel unterschreitet. Ein solcher Akku könnte daher - wie oben erläutert - gar nicht mit der beschriebenen Ladestation aufgeladen werden. Mit abgeschaltetem Akku wird der Verbraucher natürlich nicht selbstständig auf die Ladestation auffahren können, sondern er wird vom Benutzer auf die Ladestation gestellt werden. Es handelt sich dann also nicht um einen unbeaufsichtigten Betrieb, sondern der Benutzer ist anwesend und könnte einen die Elektroden kurzschließenden Fremdkörper erkennen und entfernen. In diesem Fall wäre es also optional durchaus zulässig, die Ladespannung unabhängig von der Verbrauchererkennung kurzzeitig aufzuschalten, damit auch ein zum Schutz gegen Tiefentladung abgeschalteter Akku aufgeladen werden kann. Die Zeitdauer der Aufschaltung der Ladespannung sollte dabei so bemessen sein, dass danach der Akku hinreichend stark geladen wird, um seine Abschaltung aufzuheben. Die Aufschaltung der Ladespannung kann dabei manuell z. B. über einen vom Benutzer zu betätigenden insbesondere verdeckt angebrachten Schalter (verdeckt, damit ihn nicht der Verbraucher durch seine Bewegung versehentlich betätigen kann) initiiert werden. Eine andere Möglichkeit wäre z. B. nach dem Einschalten der Netzspannung die Ladespannung einige Sekunden aufzuschalten. Der Benutzer kann dann die Ladung des Akkus bewirken, indem er kurz den Netzstecker der Ladestation zieht und wieder einsteckt.

Weitere Merkmale, Vorteile und Wirkung der Erfindung ergeben sich aus der nachfolgenden Beschreibung eines bevorzugten Ausführungsbeispiels der Erfindung sowie der beigefügten Figuren. Diese zeigen:
Figur 1 eine schematische Blockdarstellung von einer Anordnung umfassend eine Ladestation und einen Verbraucher als ein Ausführungsbeispiel der Erfindung;
Figur 2 ein Impulsdiagramm (a) und Verläufe der Spannung U über der Zeit bei (a) Leerlauf, (b) Kurzschluss und (c) Anschluss eines Verbrauchers an der Ladeschnittstelle;
Figur 3 ein schematisches Zustandsdiagramm von einem Verfahren zur Detektion eines Verbrauchers durch eine Ladestation.
Figur 4 eine Schaltung zur Impedanzmessung im Frequenzbereich.

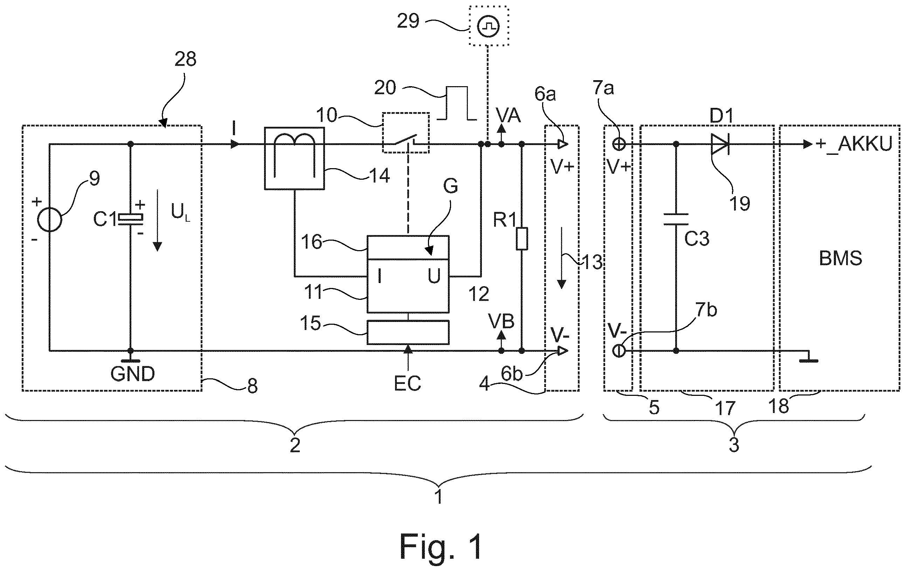

Die Figur 1 zeigt in einer stark schematisierten Darstellung eine Anordnung 1 mit einer Ladestation 2 sowie einem Verbraucher 3, hier einen Roboter. Der Verbraucher 3 ist als ein mobiler Verbraucher 3 ausgebildet, welcher selbsttätig verfahren kann. Hierzu weist der Verbraucher 3 eine Fahreinrichtung (nicht gezeigt) auf, welche beispielsweise angetriebene Räder umfasst. Der Verbraucher 3 ist beispielsweise als ein Staubsaugerroboter oder als ein Mähroboter ausgebildet, kann jedoch auch als ein Flugroboter realisiert sein. Die Ladestation 2 ist als eine Basisstation für den Verbraucher 3 ausgebildet und ermöglicht es, den Verbraucher 3 mit elektrischem Strom aufzuladen.

Zur elektrischen Kopplung zwischen der Ladestation 2 und dem Verbraucher 3 weist die Ladestation 2 eine Ladeschnittstelle 4 und der Verbraucher 3 eine Gegenschnittstelle 5 auf, welche mittels elektrischer Kontaktierung, also kontaktierend, miteinander gekoppelt werden können. Die Ladestation 2 weist Elektroden 6 a, b in der Ladeschnittstelle 4, der Verbraucher 3 weist Gegenelektroden 7 a, b in der Gegenschnittstelle 5 auf. Bei der elektrischen Kopplung werden die Elektrode 6 a mit der Gegenelektrode 7 a sowie die Elektrode 6 b mit der Gegenelektrode 7 b miteinander kontaktiert.

Die Ladestation 2 weist eine Versorgungseinrichtung 8 auf, welche zur Bereitstellung einer Ladespannung UL und eines Ladestroms I ein Schaltnetzteil 9 umfasst, welches eine Gleichspannung beispielhaft von 19 V bereitstellt. Zur Glättung ist ein Kondensator C1 vorgesehen. Die Versorgungseinrichtung 8 versorgt die Ladeschnittstelle 4 bzw. die Elektroden 6 a, b mit der Ladespannung und/oder mit dem Ladestrom I. Dabei wird zur Aufladung eines Akkus vorzugsweise ein konstanter Ladestrom geliefert, bei der Versorgungseinrichtung 8 handelt es sich in diesem Betriebsfall also vorzugsweise um eine Konstantstromquelle. Dem Fachmann ist das entsprechende Ladeverfahren als CC-(Constant Current)Ladung bekannt.

Die Ladestation 2 bzw. die Versorgungseinrichtung 8 ist in einen Ladezustand setzbar, wobei die Ladeschnittstelle 4 mit der Ladespannung und optional ergänzend mit dem Ladestrom I versorgt wird. Die Versorgungseinrichtung 8 ist auch in einen Nicht-Ladezustand setzbar, wobei die Ladespannung und/oder der Ladestrom I an der Ladeschnittstelle 4 nicht anliegt. Das Umschalten zwischen Ladezustand und Nicht-Ladezustand wird durch eine Trenneinrichtung 10 umgesetzt, welche zwischen der Versorgungseinrichtung 8 und der Ladeschnittstelle 4, insbesondere der Elektrode 6 a angeordnet ist. Die Trenneinrichtung 10 ist bei dem Ausführungsbeispiel als ein steuerbares Schaltelement realisiert.

Zwischen den Elektroden 6 a, b ist ein Belastungswiderstand 12 (auch mit "R1" bezeichnet) angeordnet, über den die Elektroden 6 a, b miteinander insbesondere untrennbar und/oder dauerhaft verbunden sind. Der Belastungswiderstand 12 weist bei diesem Ausführungsbeispiel einen Widerstand von 100 kΩ auf.

Die Ladestation 2 weist eine Detektionseinrichtung 11 auf, welche die an dem Belastungswiderstand 12 bzw. die zwischen den Elektroden 6a, b abfallende Spannung bzw. den Spannungsabfall bzw. die Spannung U (zwischen den Potentialen V+ und V-, hier Masse GND) als eine elektrische Größe G bzw. Detektionsgröße misst.

Ferner weist die Ladestation 2 eine optionale Ladestromprüfeinrichtung 14 auf, welche den über die Ladeschnittstelle 4 fließenden Ladestrom I der Versorgungseinrichtung 8 abgreift bzw. erfasst. Die Detektionseinrichtung 11 ist mit der Ladestromprüfeinrichtung 14 signaltechnisch oder schaltungstechnisch verbunden, so dass von der Detektionseinrichtung 11 der Ladestrom I erfasst wird. Die Ladestromprüfeinrichtung 14 ist beispielsweise als ein Shunt oder ein galvanisch getrennter Hall-Sensor umgesetzt. Der Abgriff des Ladestroms I erfolgt zwischen der Versorgungseinrichtung 8 und der Trenneinrichtung 10, der Abgriff der an dem Belastungswiderstand 12 abfallenden Spannung U erfolgt zwischen der Trenneinrichtung 10 und der Ladeschnittstelle 4.

Die Ladestation 2 weist eine Steuereinrichtung 16 auf, welche einen integralen Teil der Detektionseinrichtung 11 bilden kann oder als eine separate Komponente ausgebildet ist und mit dieser signaltechnisch verbunden ist. Die Steuereinrichtung 16 steuert die Trenneinrichtung 10, um die Versorgungseinrichtung 8 bzw. die Ladestation 2 zwischen dem Ladezustand und dem Nicht-Ladezustand umzuschalten.

Der Verbraucher 3 weist eine Ladeeinrichtung 17 sowie einen Energiespeicher 18, wie z. B. einen Akku, auf, wobei die Ladeeinrichtung 17 zwischen der Gegenschnittstelle 5 und dem Energiespeicher 18 elektrisch angeordnet ist, so dass der Ladestrom I von der Gegenschnittstelle 5 zu dem Energiespeicher 18 geführt ist. Ferner weist die Ladeeinrichtung 17 eine Sperrdiode 19 auf, welche zwischen der Gegenelektrode 7a und dem Energiespeicher 18 geschaltet ist, um einen Rücklaufstrom von dem Energiespeicher 18 zu der Gegenschnittstelle 5 zu verhindern.

Funktional betrachtet kann die Anordnung 1, insbesondere die Ladestation 2, eine Ankopplung oder ein Andocken des Verbrauchers 3 an der Ladestation 2, wobei die Gegenschnittstelle 5 mit der Ladeschnittstelle 4 elektrisch kontaktiert, detektieren.

Hierzu wird die Versorgungseinrichtung 8 über die Detektionseinrichtung 11 und/oder die Steuereinrichtung 16 in einen Nicht-Ladezustand gesetzt, indem die Trenneinrichtung 10 geöffnet wird.

Zur Detektion erfolgt eine Impedanzmessung im Zeitbereich. Hierbei wird periodisch die Impulsantwort des Systems bzw. der Anordnung 1 an den Lade-Elektroden 6a, b gemessen. Dazu wird als ein Testsignal 13 aus einer Spannungsquelle 28 periodisch ein kurzer Stimulationsimpuls 20 (Dauer z. B. 0,2 ms) auf die Lade-Elektroden 6a, b gegeben. Das geschieht, in dem das Schaltelement in der Trenneinrichtung 10, hier ein MOSFET, kurzzeitig durchgesteuert wird. Die Spannungsquelle 28 wird also hier durch das Schaltnetzteil 9 gebildet. Ein Testsignalgenerator 29 wird durch das Zusammenspiel von Schaltnetzteil 9, Trenneinrichtung 10 und der sie ansteuernden Steuereinrichtung 16 realisiert und ist symbolisch in der Figur 1 gezeigt.

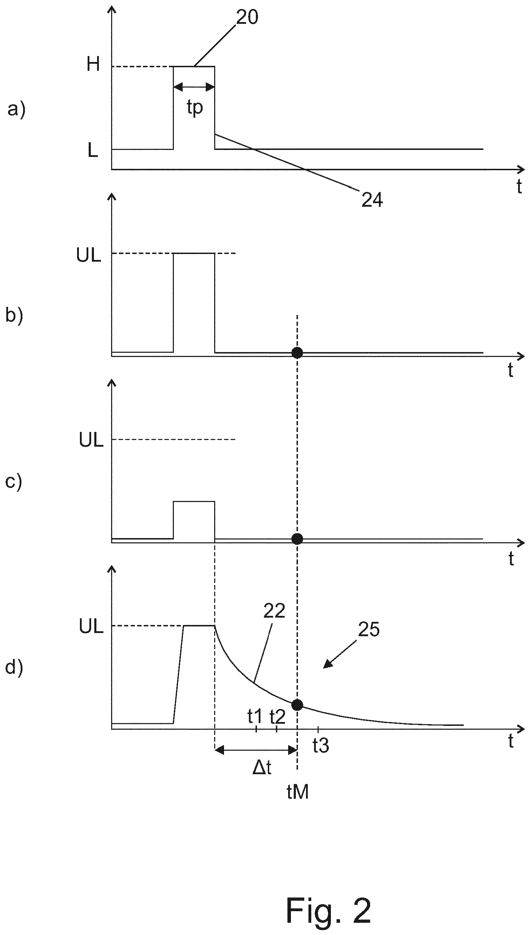

Fig. 2 zeigt ein Impulsdiagramm (vier Einzeldiagramme, jeweils aufgetragen über der Zeit t), das die Funktionsweise der Detektion erläutert. Im Diagramm Fig. 2a sieht man die Ansteuerung des Schaltelements bzw. der Trenneinrichtung 10 (Gatespannung am MOSFET). Dargestellt ist auch der an den Lade-Elektroden 6a, b anliegende und dort messbare Spannungsverlauf der Spannung U, einmal mit freiliegenden Elektroden 6a, b (Fig. 2b), einmal mit einem (hochohmigen) ohmschen Kurzschluss (Fig. 2c) der Elektroden 6a, b und schließlich mit angedocktem Verbrauchers an den Elektroden 6a, b (Fig. 2d).

Wenn die Steuerspannung am Gate des MOSFET gesteuert von der Kontrolleinheit bzw. Steuereinrichtung 16 High (H) ist, wird der MOSFET durchgesteuert und die Ladespannung wird als Spannung U kurzzeitig (bis zum Übergang auf Low L) an die Lade-Elektroden 6a, b angelegt. Dann kann man also bei Leerlauf der Elektroden 6a, b die volle Ladespannung UL als Spannung U während der Impulsdauer tp des Stimulationsimpulses messen (Fig. 2b).

Bei einem die Elektroden 6a, b kurzschließenden Fremdkörper (nicht dargestellt) wird der Signalverlauf ähnlich sein, allerdings ist die Amplitude des Signals meist deutlich geringer als die Ladespannung UL bis hin zu fast Null bei einem satten (sehr niederohmigen) Kurzschluss (Fig. 2c).

Ist dagegen der Verbrauchers angedockt (Fig. 2d), so macht sich ein Kondensator C3 als dessen maßgebliche Eingangskapazität bemerkbar, der im Verbraucher 3 zwischen dessen Gegenelektroden 7a, b verschaltet ist. In diesem Fall wird die Spannung U zwischen den Elektroden 6a, b bei Aufschaltung des Stimulus- bzw. Stimulationsimpulses 20 wegen der Aufladung des Kondensators C3 etwas länger bzw. langsamer ansteigen als in den Figuren 2b, c (als in Form einer RC-Ladekurve 25) und dann für den Rest der Impulsdauer tp konstant bleiben (z. B. etwa auf dem Wert der Ladespannung UL). Nach dem Ende des Stimulusimpulses 20 wird der Kondensator C3 langsam über den Belastungswiderstand 12 bzw. R1 entladen. Damit ergibt sich als Spanungsverlauf die typische exponentielle Entladekurve 25 einer RC-Kombination, die asymptotisch gegen Null läuft.

Indem man nun die Spannung U an den Elektroden 6a, b mit einer Zeitverzögerung Δt (z. B. 5 ms) nach dem Ende des Stimulationsimpulses 20, also zum Messzeitpunkt tM (angedeutet durch Messpunkte der aktuellen Spannung U in Fig.2b-d) misst, hat man ein sehr eindeutiges Indiz, um freie Lade-Elektroden 6a, b (Fig. 2b) sowie auch einen Kurzschluss (Fig. 2c) - nämlich jeweils U(tM) = 0 - von einem angedockten Verbraucher (Fig. 2d) - nämlich (U(tM) ungleich Null) unterscheiden zu können. Misst man zum Messzeitpunkt tM einen signifikanten Spannungspegel ungleich Null, so muss an den Elektroden 6a, b ein kapazitives Element, hier der Verbrauchers mit seiner Eingangsschaltung bzw. der Kapazität C3 anliegen, da ein Kurzschluss (Fig. 2c) eben grundsätzlich keine signifikante kapazitive Komponente aufweist.

Zur Verbesserung der Störempfindlichkeit empfiehlt es sich alternativ, nicht nur eine Messabtastung zum Messzeitpunkt tM durchzuführen, sondern mehrere (Beispielhaft zusätzliche Mess-Zeitpunkte t1, 2, 3) und die gemessenen Spannungen U über diese zu mitteln oder gar die Abstiegsflanke 22 der RC-Entladekurven 25 in die Auswertung miteinzubeziehen, also zu überprüfen, dass aufeinanderfolgende Messungen (tM, t1 - 3) jeweils monoton fallende Werte der Spannung U aufweisen müssen.

Der Belastungswiderstand 12 bzw. R1 kann optional auf weggelassen werden, da eine (rasche) Entladung der Kapazität C3 für die Messung nicht notwendigerweise erforderlich ist. Ohne Belastungswiderstand 12 bzw. R1 erfolgt die Messung aber sehr hochohmig und ist dadurch empfindlich gegen elektrostatische Aufladung der Ladeschnittstelle 4, wie sie gerade in Bodennähe speziell bei Kunstfaserteppichen leicht auftreten können.

Die Stimulationsimpulse 20 können in kurzem Abstand (z. B. weniger als 100 ms, z. B. 30 ms) auf die Lade-Elektroden 6a, b gegeben werden, um z. B. die Ladespannung UL noch rechtzeitig auf einen selbstständig auf die Ladestation 2 auffahrenden Verbraucher 3 aufzuschalten, bevor der Verbraucher 3 den Kontakt mit den Lade-Elektroden 6a, b verliert.

Muss dagegen nur das Aufsetzen des Verbrauchers 3 durch den Benutzer erkannt werden, genügt alternativ ein Abstand der Stimulationsimpulse 20 im Sekundenbereich.

Sobald von der Detektionseinrichtung 11 also eine passende Spannung U usw. detektiert wird, wird auf ein korrektes Andocken des Verbrauchers 3 an der Ladestation 2 geschlossen und die Trenneinrichtung 10 wird geschlossen, um die Versorgungseinrichtung 8 von dem Nicht-Ladezustand in den Ladezustand umzuschalten.

Sobald einmal der Verbraucher 3 beim Andocken erkannt und die Ladespannung UL über das Schaltelement bzw. die Trenneinrichtung 10 aufgeschaltet wurde, lässt sich nur noch die Ladespannung UL feststellen, die Impedanzmessung also nicht mehr durchführen. Daher ist eine Abdockerkennung erforderlich. Hierzu wird von Zeit zu Zeit (z. B. alle paar Sekunden) die Ladespannung UL (Trenneinrichtung 10 geöffnet) unterbrochen und während der Unterbrechung dann erneut das Detektionsverfahren durchgeführt.

Ein dezidierter Stimulusimpuls 20 während der Unterbrechung ist dabei überflüssig, da unmittelbar vor der Unterbrechung noch die Ladespannung UL an den Elektroden 6a, b anlag und den Kondensator C3 auflud. Es ergibt sich damit die abfallende Flanke 24 des Stimulationsimpulses 20.

Alternativ oder ergänzend kann auch der Ladestrom I gemessen und überwacht werden, um eine technisch in Bezug auf den Akku bzw. Energiespeicher 18 nachteilige Unterbrechung des Ladevorgangs zu verhindern.

Optional kann das vorliegende auch mit einem passiven Detektionsverfahren (siehe oben) kombiniert werden. Man hat dann den Vorteil des recht schnellen und sicheren passiven Verfahrens zur Erkennung des autonomen Andockens des Roboters bzw. Verbrauchers 3, kann aber gleichwohl, dann allerdings mit deutlich reduzierter Geschwindigkeit, mittels der Impedanzmessung im Zeitbereich auch einen Roboter bzw. Verbraucher 3 mit vom Batteriemanagementsystem BMS abgeschaltetem Akku, der vom Benutzer auf die Basisstation, d. h. Ladestation 2, gestellt wird, erkennen und aufladen. Dazu wird während der Andockerkennung kontinuierlich jede Millisekunde eine passive Messung durchgeführt. Alle paar Sekunden (im dargestellten Beispiel alle 3 s) wird die passive Messung kurz unterbrochen und ein Stimulusimpuls 20 aufgeschaltet und wie zuvor beschrieben kurz die Impulsantwort (Spannung U) nach der Zeit Δt gemessen usw. Falls dabei keine signifikante Kapazität (also keine Kapazität C3) festgestellt wird, erfolgt wieder die passive Messung. Die Kombination bietet gegenüber der reinen Impedanzmessung den Vorteil des deutlich verringerten Energieeintrags in einen möglichen Kurzschluss, da nun nur noch alle paar Sekunden statt z. B. mit 30 Hz eine aktive Messung erfolgt.

Bei dem der erfolgreichen Detektion des Verbrauchers 3 nachfolgenden Laden des Energiespeichers 18 durch die Versorgungseinrichtung 8 wird also über die Detektionseinrichtung 11 der Ladestrom I überwacht. Sobald der Ladestrom I einen vorgeben Wert unterschreitet wird wahlweise auf ein Abdocken des Verbrauchers 3 von der Ladestation 2 oder von einem Abschluss des Ladevorgangs ausgegangen. Um diese zwei Zustände unterscheiden zu können kann zum einen die Trenneinrichtung 10 geöffnet werden und nochmals die Detektion durchgeführt werden, um zu überprüfen ob der Verbraucher 3 noch an der Ladestation 2 angedockt ist.

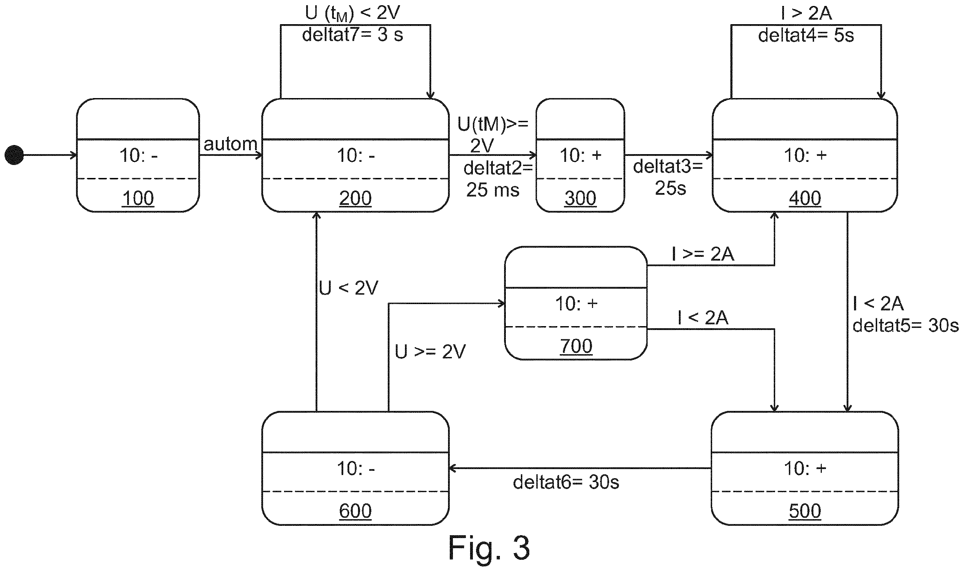

In der Figur 3 ist ein Zustandsdiagramm zur Überwachung von dem Verfahren zur Detektion des Verbrauchers 3 in der Ladestation 2 gezeigt: Dabei bedeutet das Symbol "10: -", dass die Trenneinrichtung 10 geöffnet ist und "10: +", dass die Trenneinrichtung 10 geschlossen ist. In diesem Ausführungsbeispiel erfolgt die Ladung mit einem Konstantstrom I von 2,2 A bis 2,5 A. Das Schaltnetzteil 9 ist als eine Konstantstromquelle ausgebildet.

In einem Schritt 100 wird zur Initialisierung von der Versorgungseinrichtung 8 ein Ladestrom und/oder eine Ladespannung bereitgestellt, jedoch zugleich die Trenneinrichtung 10 (Figur 2: 10: -) geöffnet, so dass die Ladeschnittstelle 4 von Seiten der Ladestation 2 spannungslos gesetzt ist.

In einem Schritt 200 erfolgt bei geöffneter Trenneinrichtung 10 (Figur 2: 10: -) eine Andockerkennung und es wird der Stimulationspuls 20 erzeugt und der Spannungsabfall bzw. die Spannung U an dem Belastungswiderstand 12 zum Messzeitpunkt tM gemessen. Sofern der Spannungsabfall kleiner als 2V ist, wird die Messung zyklisch wiederholt, in diesem Ausführungsbeispiel alle 3 Sekunden (deltat7 = 3 s). Zyklisch wiederholt wird auch eine passive Messung in einem Zeitabstand von deltat1 = 1 ms. Figur 3 stellt damit die Kombination des aktiven Verfahrens im Zeitbereich mit dem passiven Verfahren mit Leckstrommessung (wie in der parallelen Patentanmeldung beschrieben, siehe oben) dar.

Sobald ein Spannungsabfall größer als 2 V für eine vorgebbare Dauer, in diesem Beispiel von 25 ms (deltat2 > 25 ms) von der Detektionseinrichtung 11 erfasst wird, schließt die Steuereinrichtung 16 in einem Schritt 300 die Trenneinrichtung 10 (Figur 2: 10: +), so dass an der Ladeschnittstelle 4 eine Ladespannung anliegt und ein Ladestrom fließen kann. Die Versorgungseinrichtung 8 wird in den Ladezustand gesetzt. Der Ladezustand wird zumindest für eine vorgebbare Dauer (wait), bei diesem Ausführungsbeispiel von 25 Sekunden (deltat3 = 25 s), gehalten. Im dargestellten Ausführungsbeispiel dient diese vorgebbare fixe Zeit mit aufgeschalteter Ladespannung zum einen dazu, dem Verbraucher 3, der an die Ladestation 2 angedockt hat, ausreichend Zeit zur Einleitung des Ladevorgangs zu geben, und zum anderen, dem Verbraucher 3, der zwar anzudocken versuchte und dabei die Verbraucherdetektion ausgelöst hat, dabei aber nicht rechtzeitig stoppte und die Ladeschnittstelle 4 überfuhr, bessere Voraussetzungen für den nächsten Andockversuch zu schaffen.

In einem Schritt 400 erfolgt der Ladevorgang bzw. wird dieser fortgesetzt. Dabei wird der Ladestrom über die Ladestromprüfeinrichtung 14 durch die Detektionseinrichtung 11 erfasst und zyklisch, in diesem Ausführungsbeispiel alle 5 Sekunden (deltat4 = 5s), geprüft. Sofern der Ladestrom über einen vorgebbaren Wert, in diesem Ausführungsbeispiel größer als 2 A, liegt, wird der Ladevorgang weitergeführt. Für den Fall, dass der Ladestrom I für eine vorgebbare Zeitdauer, bei diesem Ausführungsbeispiel für 30 Sekunden (delta5=30s), unter dem vorgebbaren Wert liegt, wird zunächst darauf geschlossen, dass der Ladevorgang des Energiespeichers 18 abgeschlossen ist.

In einem Schritt 500 bleibt die Trenneinrichtung 10 (Figur 2: 10: +) weiterhin geschlossen, so dass die Ladespannung U anliegt und der Ladestrom I zumindest bereitgestellt ist. Da der Verbraucher 3 die Ladespannung U als Indikator (dass er sich auf der Ladestation 2 befindet) benötigt, bleibt die Ladespannung U aufgeschaltet. Daher wird die Steuereinrichtung 16 in kurzen Zeitintervallen (z. B. von wenigen Sekunden) die Ladespannung U kurz unterbrechen und eine Spannungsmessung durchführen, wobei man also die implizite (negative) Sprungantwort (Abschaltung der Spannung beim Übergang von Zustand 500 auf Zustand 600 nutzt. Bei erfolgreicher Detektion geht die Steuereinrichtung 16 davon aus, dass sich der Verbraucher 3 weiterhin auf der Ladestation 2 befindet und schaltet die Ladespannung U erneut auf. Andernfalls hat der Verbraucher 3 offensichtlich die Ladestation 2 verlassen und die Ladespannung U wird zur Sicherheit von der Steuereinrichtung 16 über die Trenneinrichtung 10 abgeschaltet. Optional kann wieder holt ein Stimulationsimpuls 20 aufgeschaltet werden.

Somit wird zyklisch, bei diesem Ausführungsbeispiel alle 30s(deltat6=30s), in einem Schritt 600 eine Abdockerkennung durchgeführt. Bei dem gezeigten Ausführungsbeispiel erfolgt die Abdockerkennung über den Stimulationsimpuls 20 und den Belastungswiderstand 12, wobei die Trenneinrichtung 10 von der Steuereinrichtung 16 und/oder der Detektionseinrichtung 11 geöffnet wird (Figur 2: 10: -) und der Spannungsabfall U an dem Belastungswiderstand 12 von der Detektionseinrichtung 11 erfasst wird.

Für den Fall, dass der Spannungsabfall U über dem vorgebbaren Wert, in diesem Beispiel von 2 V, liegt, wird davon ausgegangen, dass der Verbraucher 3 an der Ladestation 2 angedockt ist. Dann wird durch die Detektionseinrichtung 11 und/oder Steuereinrichtung 16 die Trenneinrichtung 10 in einem Schritt 700 wieder geschlossen und es erfolgt eine Ladestrommessung durch die Ladestromprüfeinrichtung 14 und die Detektionseinrichtung 11. Sofern der Ladestrom I über dem vorgebbaren Wert, in diesem Fall von 2 A, liegt wird zu dem Schritt 400 zurückgekehrt. Für den Fall, dass der Ladestrom unter dem vorgebbaren Wert liegt, wird zu dem Schritt 500 zurückgegangen.

Für den Fall, dass in dem Schritt 600 der Spannungsfall U unter dem vorgebbaren Wert liegt, wird davon ausgegangen, dass der Verbraucher 3 von der Ladestation 2 abgekoppelt bzw. abgedockt ist, und es wird zu dem Schritt 200 zurückgekehrt.

Neben der Messung im Zeitbereich ist alternativ auch eine Messung im Frequenzbereich möglich. Man misst dann also nicht die Impuls- oder Sprungantwort des an den Lade-Elektroden 6a, b befindlichen Systems, sondern z. B. den Frequenzverlauf, d. h. eine Frequenz als elektrische Größe G.

In Fig. 1. ist dann der Spannungsmesseingang "U" zum Mikrokontroller bzw. an der Detektionseinrichtung 11 überflüssig. Dafür verfügt der Mikrokontroller zusätzlich über einen Impulseingang EC der mit einem Frequenzzähler 15 verbunden ist.

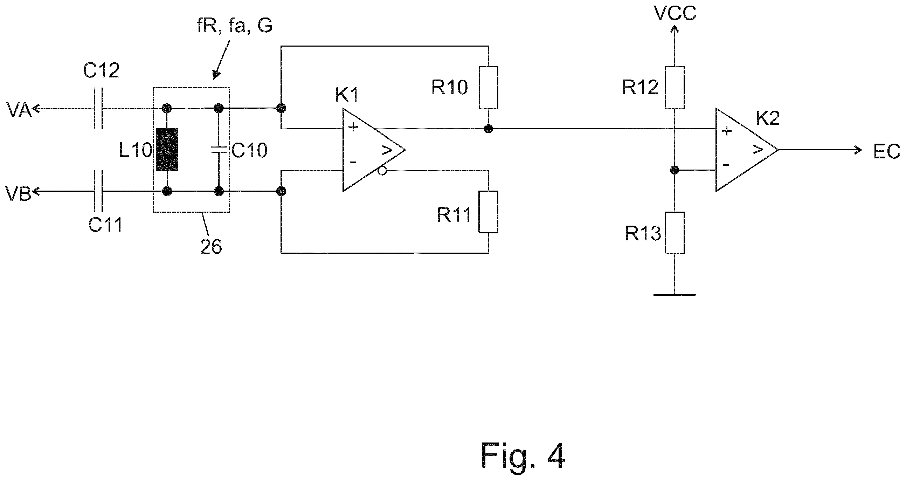

Zusätzlich ist die in Fig. 4 dargestellte Schaltung erforderlich. Die Schaltung ist stark vereinfacht, insbesondere wurde auf die Darstellung der Stromversorgungsleitungen und Start- und Stoppsignalen verzichtet. Es handelt sich dabei um eine Oszillatorschaltung, die ein rechteckförmiges Ausgangssignal ausgibt. Kern ist ein durch den Kondensator C10 und die Spule L10 gebildeter Parallel-Schwingkreis 26 (gestrichelt umrahmt). Der Wert des Kondensators C10 sollte in der Größenordnung der erwarteten Verbraucherkapazität (des Kondensators C3) liegen, also im dargestellten Beispiel z. B. bei 33 nF und L10 sollte dann so gewählt werden, dass die Resonanzfrequenz des Schwingkreises zwischen 30 kHz und 500 kHz liegt.

Durch den ersten Komparator K1 wird der Schwingkreis über die RückkopplungsWiderstände R10 und R11 zu einer Oszillation bei dessen ureigener Resonanzfrequenz fR angeregt. Es findet im Beispiel ein Komparator K1 mit komplementären Ausgängen Verwendung. Solche Komparator-ICs sind beispielsweise als IC LT1713/LT1714 von Linear Technology bekannt. Die nachgeschaltete (zweite) Komparatorstufe K2 dient nur dazu, das Oszillatorsignal in ein sauberes Rechtecksignal umzuwandeln, das dann dem Frequenzzähler 15 (über den Impulseingang EC) zugeführt wird. Der Referenzpegel für diesen zweiten Komparator der Komparatorstufe K2 wird durch die Widerstände R12 und R13 erzeugt. Über die Kopplungs- oder Koppelkondensatoren C11 und C12 wird der Schwingkreis mit der in Fig. 1 dargestellten Schaltung verbunden (Verbindungspunkte VA, VB). Insbesondere liegen also die Lade-Elektroden 6a, b dadurch wechselstrommäßig parallel zum Parallel-Schwingkreis 26, während die Koppelkondensatoren C11,12 zugleich für eine galvanische Trennung sorgen. Die Kapazitätswerte der Koppelkondensatoren C11,12 sollten groß gegen den Wert des Kondensators C10 sein, also in diesem Beispiel 2,2 µF betragen. Dafür kommen vorzugsweise unipolare Keramikkondensatoren in Frage.

Die Kapazitätsmessung selbst kann bzw. darf nur bei offenem Schaltelement in der Trenneinrichtung 10 erfolgen, bei geschlossenem Schaltelement würde die Schaltung aus Fig. 4 in Richtung der Verbindungspunkte V1, B nämlich primär den sehr großen Glättungs-Kondensator C1 "sehen" und den zusätzlichen Beitrag der Verbraucherkapazität (Kondensator) C3 messtechnisch nicht erfassen können. Man könnte den Kondensator C1 zwar mittels einer Drossel davon entkoppeln, doch wäre das im angegebenen Frequenzbereich sehr aufwändig. Damit ergibt sich auch bei diesem Verfahren ganz automatisch ein "selbsthaltender Effekt" wie schon zuvor bei der Zeitbereichsmessung beschrieben. Nur stört diesmal nicht die Ladespannung UL selbst, sondern eben der Glättungs-Kondensator C1.

Die Frequenzzählung kann einfach durch den steuernden Mikrokontroller, also die Detektionseinrichtung 11, selbst durchgeführt werden. Dazu wird der Ausgang der Komparatorstufe K2 (also der Impulseingang EC) mit einem Impulseingang des Mikrokontrollers bzw. der Detektionseinrichtung 11 verbunden, der intern mit einer Zählstufe verbunden ist. Setzt man den Zähler zunächst zurück und lässt ihn dann für eine vordefinierte Zeit laufen, so wird er alle Impulse am Impulseingang EC registrieren und nach der vordefinierten Zeit ist der Zählerstand proportional zur aktuellen Oszillationsfrequenz bzw. Schwingfrequenz fa des Schwingkreises 26 als Größe G.

Bei freien Lade-Elektroden 6a, b wird der Schwingkreis 26 auf seiner Resonanzfrequenz fa = fR schwingen. Die Koppelkondensatoren C11 und C12 haben de facto keinen Einfluss, da die parasitäre Kapazität zwischen den Lade-Elektroden 6a, b allenfalls wenige pF betragen wird.

Hat aber der Verbrauchers angedockt, liegt die Kapazität C3 in Reihe mit den Koppelkapazitäten C11 und C12 parallel zum Schwingkreis-Kondensator C10. Da C11 und C12 wesentlich größer als C3 sind, wird der Wert von C3 die Serienschaltung der drei Kondensatoren C11, C3 und C12 dominieren. Folglich liegt bei angedocktem Verbrauchers de facto C3 zum parallel zur Schwingkreiskapazität C10. Damit wird die Oszillationsfrequenz fa des Schwingkreises 26 deutlich aber nicht drastisch gegenüber der Resonanzfrequenz fR reduziert. Die Reduktion der Frequenz fa kann einfach mit Hilfe des angeschlossenen Frequenzzählers 15 ausgewertet werden.

Im Falle eines die Lade-Elektroden 6a, b kurzschließenden metallischen Fremdkörpers liegt die Reihenschaltung der beiden Koppelkondensatoren C11 und C12 sowie der (sehr geringen) Impedanz des Fremdkörpers parallel zur Schwingkreis 26. Dies bedeutet, dass eine sehr große Kapazität (im erwähnten Beispiel rund 1 µF) parallel zum Schwingkreiskondensator C10 liegt und dadurch die Oszillationsfrequenz fa des Schwingkreises 26 drastisch gegenüber der Resonanzfrequenz fR reduziert.

Damit hat man nun ein Merkmal einfach anhand der von der Zählerstufe bzw. dem Frequenzzähler 15 gemessenen Frequenz fa zwischen erstens: freien Elektroden 6a, b, zweitens: einem Kurzschluss über den Lade-Elektroden 6a, b und drittens: einem angedockten Verbraucher3 zu unterscheiden. Die Steuerung des Schaltelements in der Trenneinrichtung 10 kann dann ganz analog zu den passiven Verfahren bzw. zur Impedanzmessung im Zeitbereich erfolgen. Auch der "selbsthaltende Effekt" ist zu (ohne Entkopplung durch eine Drossel) berücksichtigen und der Ladestrom I sollte auch hier vorteilhafterweise überwacht werden. Wegen der starken Ähnlichkeit mit den anderen Verfahren wird auf die explizite Wiedergabe in einem Zustandsdiagramm gemäß Fig. 4 hier verzichtet.

Eine weitere Möglichkeit die mögliche kapazitive Impedanz des Systems an den Lade-Elektroden 6a, b (Luft, kurzschließender Fremdkörper, Verbraucher) festzustellen, besteht darin, galvanisch entkoppelt Wechselspannungssignale geringer Amplitude mit unterschiedlicher Frequenz an die Lade-Elektroden 6a, b einzukoppeln und dann den jeweils fließenden Strom durch eine der Elektroden 6a, b zu messen. Bei angedocktem Verbrauchers muss der Stromfluss aufgrund der Verbraucher-Kapazität C3 frequenzabhängig sein, bei einem Kurzschluss dagegen nicht.

### Bezugszeichenliste

- 1: Anordnung
- 2: Ladestation
- 3: Verbraucher
- 4: Ladeschnittstelle
- 5: Gegenschnittstelle
- 6a, b: Elektroden
- 7a, b: Gegenelektroden
- 8: Versorgungseinrichtung
- 9: Schaltnetzteil
- 10: Trenneinrichtung
- 11: Detektionseinrichtung
- 12: Belastungswiderstand
- 13: Testsignal
- 14: Ladestromprüfeinrichtung
- 15: Frequenzzähler
- 16: Steuereinrichtung
- 17: Ladeeinrichtung
- 18: Energiespeicher
- 19: Sperrdiode
- 20: Stimulationsimpuls
- 22: Abstiegsflanke
- 24: Flanke
- 25: Lade-/Entladekurve
- 26: Schwingkreis
- 28: Spannungsquelle
- 29: Testsignalgenerator

- G: Größe
- C1: Kondensator
- R1: Belastungswiderstand
- I: Ladestrom
- U: Spannung
- t: Zeit
- GND: Masse
- BMS: Batteriemanagementsystem
- V+, -: Potential
- H: High
- L: Low
- tp: Impulsdauer
- UL: Ladespannung
- C3: Kondensator
- Δt: Zeitverzögerung
- tM: Messzeitpunkt
- t1 - 3: Zeitpunkte
- EC: Impulseingang
- C10: Kondensator
- L10: Spule
- K1: Komparator (erster)
- R10, 11: Widerstand
- fR: Resonanzfrequenz
- fa: aktuelle Schwingfrequenz
- R12, 13: Widerstand
- K2: Komparatorstufe (zweite)
- C11, 12: Koppelkondensatoren
- VA, B: Verbindungspunkt

## Patentansprüche

1. Ladestation (2) für einen bestimmungsgemäßen Verbraucher (3),
mit einer Ladeschnittstelle (4) mit Elektroden (6a, b) zur kontaktierenden Ankopplung des Verbrauchers (3), wobei der Verbraucher (3) eine Gegenschnittstelle (5), eine Ladeeinrichtung (17) und einen Energiespeicher (18) aufweist, wobei die Gegenschnittstelle (5) über die Ladeeinrichtung (17) mit dem Energiespeicher (18) verschaltet ist, so dass der Energiespeicher (18) über die Gegenschnittstelle (5) aufladbar ist,
mit einer Versorgungseinrichtung (8) zur Versorgung der Ladeschnittstelle (4), wobei die Versorgungseinrichtung (8) in einen Ladezustand und in einen Nicht-Ladezustand setzbar ist,
mit einer Detektionseinrichtung (11) zur Detektion der Ankopplung des Verbrauchers (3) an die Ladeschnittstelle (4),
**dadurch gekennzeichnet, dass**
die Detektionseinrichtung (11) ausgebildet ist,
a) bei einem Nicht-Ladezustand der Versorgungseinrichtung (8) ein Testsignal (13) an die Ladeschnittstelle (4) anzulegen und in diesem Zusammenhang eine elektrische Größe (G) basierend auf der komplexwertigen elektrischen Ausgangsimpedanz der Ladeschnittstelle (4) als Detektionsgröße zur Detektion der Ankopplung des Verbrauchers (3) an die Ladeschnittstelle (4) zu erfassen,
wobei die Ladestation (2) einen Testsignalgenerator (29) zum Anlegen des impulsförmigen Testsignals (13) zwischen den Elektroden (6a,b) vor und/oder während der Erfassung der elektrischen Größe (G) enthält, wobei als Testsignal (13) ein Spannungsimpuls oder ein Spannungssprung vorgegeben ist, und die Detektionseinrichtung (11) dazu ausgebildet ist, die Erfassung der elektrischen Größe (G) im Zeitbereich durchzuführen, wobei von der Detektionseinrichtung (11) dann die Impuls- / Sprungantwort gemessen und ausgewertet wird,
und die Detektionseinrichtung (11) ausgebildet ist,
b) sobald die Ankopplung des Verbrauchers (3) erkannt wurde, und die Versorgungseinrichtung (8) in den Ladezustand gesetzt ist,
b1) entweder von Zeit zu Zeit die Versorgungseinrichtung (8) in den Nicht-Ladezustand zu setzten und währenddessen dann erneut das Detektionsverfahren gemäß a) durchzuführen,
b2) oder einen Ladestrom zu messen und zu überwachen, um eine Unterbrechung des Ladevorgangs zu verhindern.

2. Ladestation (2) nach Anspruch 1, **dadurch gekennzeichnet, dass** die Detektionsgröße als elektrische Ausgangskapazität und/oder ohmscher Ausgangswiderstand zwischen den Elektroden (6a, b) ausgebildet ist.

3. Ladestation (2) nach Anspruch 1 oder 2, **dadurch gekennzeichnet, dass** diese einen Belastungswiderstand (12) zwischen den Elektroden (6a, b) der Ladeschnittstelle (4) enthält.

4. Ladestation (2) nach einem der vorhergehenden Ansprüche, **dadurch gekennzeichnet, dass** die Detektionseinrichtung (11) dazu ausgebildet ist, eine Detektion des Verbrauchers (3) nur festzustellen, wenn die elektrische Größe (G) im Zeitbereich einer RC-Lade- und/oder Entladekurve (25) zwischen den Elektroden (6a, b) entspricht, die mit der Eingangskapazität des bestimmungsgemäß angeschlossenen Verbrauchers (3) im Einklang steht.

5. Ladestation (2) nach einem der vorhergehenden Ansprüche, **dadurch gekennzeichnet, dass** die Ladestation (2) einen Testsignalgenerator (29) zum Anlegen eines Testsignals zwischen den Elektroden (6a, b) vor und/oder während der Erfassung der elektrischen Größe (G) enthält, und die Detektionseinrichtung (11) dazu ausgebildet ist, die Erfassung der elektrischen Größe (G) im Frequenzbereich durchzuführen.

6. Ladestation (2) nach Anspruch 5, **dadurch gekennzeichnet, dass** die Ladestation (2) einen LC-Schwingkreis (26) enthält, dessen Kondensator (C1) parallel zu den Kontakten geschaltet ist, und einen Frequenzzähler (15) zur Ermittlung der aktuellen Schwingfrequenz (fa) des Schwingkreises (26) enthält, und die Detektionseinrichtung (11) dazu ausgebildet ist, eine Detektion des Verbrauchers (3) nur festzustellen, wenn die Schwingfrequenz (fa) sich in einem vorgebbaren Wertebereich unterhalb der Resonanzfrequenz (fR) des Schwingkreises befindet.

7. Anordnung (1), umfassend die Ladestation (2) nach einem der vorhergehenden Ansprüche und den Verbraucher (3).

8. Verfahren zur Detektion des Verbrauchers (3) durch die Ladestation (2) nach einem der Ansprüche 1 bis 6 und/oder in einer Anordnung (1) nach Anspruch 7, **dadurch gekennzeichnet, dass**
a) bei einem Nicht-Ladezustand der Versorgungseinrichtung (8) ein Testsignal (13) an die Ladeschnittstelle (4) angelegt wird und in diesem Zusammenhang eine elektrische Größe (G) basierend auf der elektrischen Ausgangsimpedanz der Ladeschnittstelle (4) als Detektionsgröße zur Detektion der Ankopplung des Verbrauchers (3) an die Ladeschnittstelle (4) erfasst wird, und
b) sobald die Ankopplung des Verbrauchers (3) erkannt wurde, und die Versorgungseinrichtung (8) in den Ladezustand gesetzt wurde,
b1) entweder von Zeit zu Zeit die Versorgungseinrichtung (8) in den Nicht-Ladezustand gesetzt wird und währenddessen dann erneut das Detektionsverfahren gemäß a) durchgeführt wird,
b2) oder ein Ladestrom gemessen und überwacht wird, um eine Unterbrechung des Ladevorgangs zu verhindern.

9. Verfahren nach Anspruch 8, **dadurch gekennzeichnet, dass** es als aktives Verfahren in einer Unterbrechungspause eines passiven Verfahrens zur Detektion des Verbrauchers (3) durchgeführt wird, bei dem beim Nicht-Ladezustand der Versorgungseinrichtung (8) kein Testsignal (13) an die Ladeschnittstelle (4) angelegt wird.

## Claims

1. Charging station (2) for a conventional load (3),
having a charging interface (4) with electrodes (6a, b) for a contacting coupling of the load (3), wherein the load (3) has a counter interface (5), a charging facility (17) and an energy storage device (18), wherein the counter interface (5) is connected to the energy storage device (18) by way of the charging facility (17) so that the energy storage device (18) can be charged by way of the counter interface (5),
having a supply facility (8) for supplying the charging interface (4), wherein the supply facility (8) can be set in a charging state and in a non-charging state,
having a detection facility (11) for detecting the coupling of the load (3) to the charging interface (4),
**characterised in that**
the detection facility (11) is embodied,
a) to apply a test signal (13) to the charging interface (4) when the supply facility (8) is in a non-charging state and in this context to record an electrical variable (G) on the basis of the complex-value electrical output impedance of the charging interface (4) as a detection variable for detecting the coupling of the load (3) to the charging interface (4),
wherein the charging station (2) contains a test signal generator (29) for applying the pulse-shaped test signal (13) between the electrodes (6a, b) before and/or during the recording of the electrical variable (G), wherein a voltage pulse or a voltage jump is predetermined as a test signal (13), and the detection facility (11) is embodied to carry out the detection of the electrical variable (G) in the time range, wherein the pulse/jump response is measured and evaluated by the detection facility (11),
and the detection facility (11) is embodied,
b) once the coupling of the load (3) has been identified and the supply facility (8) is set into the charging state,
b1) either from time to time to set the supply facility (8) into the non-charging state and in the meantime then again to carry out the detection method according to a),
b2) or to measure a charging current and to monitor the same in order to prevent an interruption in the charging process.

2. Charging station (2) according to claim 1, **characterised in that** the detection variable is embodied as an electrical output capacitance and/or ohmic output capacitance between the electrodes (6a, b).

3. Charging station (2) according to claim 1 or 2, **characterised in that** this contains a loading resistance (12) between the electrodes (6a, b) of the charging interface (4).

4. Charging station (2) according to one of the preceding claims, **characterised in that** the detection facility (11) is embodied only to establish a detection of the load (3) when the electrical variable (G) in the time range corresponds to an RC charging and/or discharging curve (25) between the electrodes (6a, b), which conforms with the input capacitance of the conventionally connected load (3).

5. Charging station (2) according to one of the preceding claims, **characterised in that** the charging station (2) contains a test signal generator (29) for applying a test signal between the electrodes (6a, b) before and/or during the detection of the electrical variable (G) and the detection facility (11) is embodied to carry out the recording of the electrical variable (G) in the frequency range.

6. Charging station (2) according to claim 5, **characterised in that** the charging station (2) contains an LC oscillating circuit (26), the capacitor (C1) of which is connected in parallel to the contacts, and contains a frequency counter (15) for determining the current oscillating frequency (fa) of the oscillating circuit (26), and the detection facility (11) is embodied to only establish a detection of the load (3) when the oscillating frequency (fa) is disposed in a predeterminable value range below the resonance frequency (fR) of the oscillating circuit.

7. Arrangement (1), comprising the charging station (2) according to one of the preceding claims and the load (3).

8. Method for detecting the load (3) by the charging station (2) according to one of claims 1 to 6, and/or in an arrangement (1) according to claim 7, **characterised in that**
a) with a non-charging state of the supply facility (8), a test signal (13) is applied to the charging interface (4) and in this context an electrical variable (G) is detected on the basis of the electrical output impedance of the charging interface (4) as a detection variable for detecting the coupling of the load (3) to the charging interface (4), and
b) once the coupling of the load (3) has been identified, and the supply facility (8) has been set in the charging state,
b1) either from time to time the supply facility (8) is set into the non-charging state and in the meantime the detection method is then again carried out according to a),
b2) or a charging current is measured and monitored in order to prevent an interruption to the charging process.

9. Method according to claim 8, **characterised in that** it is carried out as an active method in an interruption pause of a passive method for detecting the load (3), in which during a non-charging state of the supply facility (8), no test signal (13) is applied to the charging interface (4).

## Revendications

1. Station de charge (2) pour un consommateur conforme à sa destination (3),
avec une interface de charge (4) avec des électrodes (6a, b) pour le couplage de contact du consommateur (3), le consommateur (3) présentant une contre-interface (5), un dispositif de charge (17) et un accumulateur d'énergie (18), la contre-interface (5) étant connectée via le dispositif de charge (17) à l'accumulateur d'énergie (18), de sorte que l'accumulateur d'énergie (18) est rechargeable via la contre-interface (5),
avec un dispositif d'alimentation (8) pour l'alimentation de l'interface de charge (4), le dispositif d'alimentation (8) pouvant être placé dans un état de charge et dans un état de non-charge,
avec un dispositif de détection (11) pour la détection du couplage du consommateur (3) à l'interface de charge (4),
**caractérisée en ce que**, le dispositif de détection (11) est formé,
a) afin de créer, en présence d'un état de non-charge du dispositif d'alimentation (8), un signal de test (13) au niveau de l'interface de charge (4) et de saisir dans ce contexte une grandeur électrique (G) fondée sur l'impédance de sortie électrique à valeur complexe de l'interface de charge (4) sous forme de grandeur de détection pour la détection du couplage du consommateur (3) à l'interface de charge (4),
la station de charge (2) contenant un générateur de signal de test (29) pour la création du signal de test de type impulsionnel (13) entre les électrodes (6a, b) avant et/ou pendant la saisie de la grandeur électrique (G), une impulsion de tension ou un saut de tension étant prescrit comme signal de test (13), et le dispositif de détection (11) étant formé afin d'effectuer la saisie de la grandeur électrique (G) durant la période, le dispositif de détection (11) mesurant et évaluant alors la réponse d'impulsion / de saut,
et le dispositif de détection (11) étant formé,
b) dès que le couplage du consommateur (3) a été détecté et que le dispositif d'alimentation (8) est placé en état de charge,
b1) soit afin de placer de temps à autres le dispositif d'alimentation (8) dans l'état de non-charge et d'effectuer pendant ce temps à nouveau la procédure de détection selon a),
b2) soit afin de mesurer et surveiller un courant de charge, afin d'empêcher une interruption du processus de charge.

2. Station de charge (2) selon la revendication 1, **caractérisée en ce que** la grandeur de détection est formée sous la forme d'une capacité de sortie électrique et/ou d'une résistance de sortie ohmique entre les électrodes (6a, b).

3. Station de charge (2) selon la revendication 1 ou 2, **caractérisée en ce que** celle-ci contient une résistance de charge (12) entre les électrodes (6a, b) de l'interface de charge (4).

4. Station de charge (2) selon l'une des revendications précédentes, **caractérisée en ce que** le dispositif de détection (11) est formé afin de constater une détection du consommateur (3) uniquement lorsque la grandeur électrique (G) correspond, durant la période, à une courbe de charge et/ou de décharge RC (25) entre les électrodes (6a, b) en adéquation avec la capacité d'entrée du consommateur conforme à sa destination (3) raccordé.

5. Station de charge (2) selon l'une des revendications précédentes, **caractérisée en ce que** la station de charge (2) contient un générateur de signal de test (29) pour la création d'un signal de test entre les électrodes (6a, b) avant et/ou pendant la saisie de la grandeur électrique (G) et le dispositif de détection (11) est formé afin d'effectuer la saisie de la grandeur électrique (G) dans la gamme de fréquences.

6. Station de charge (2) selon la revendication 5, **caractérisée en ce que** la station de charge (2) contient un circuit oscillant LC (26), dont le condensateur (C1) est raccordé en parallèle par rapport aux contacts, et un compteur de fréquence (15) pour la détermination de la fréquence d'oscillation actuelle (fa) du circuit oscillant (26), et le dispositif de détection (11) est formé afin de constater une détection du consommateur (3) uniquement lorsque la fréquence d'oscillation (fa) se trouve dans une plage de valeurs prédéterminable inférieure à la fréquence de résonance (fR) du circuit oscillant.

7. Agencement (1), comprenant la station de charge (2) selon l'une des revendications précédentes et le consommateur (3).

8. Procédé pour la détection du consommateur (3) par la station de charge (2) selon l'une des revendications 1 à 6 et/ou dans un agencement (1) selon la revendication 7, **caractérise en ce que**
a) en présence d'un état de non-charge du dispositif d'alimentation (8), un signal de test (13) est créé au niveau de l'interface de charge (4) et dans ce contexte une grandeur électrique (G) fondée sur l'impédance de sortie électrique de l'interface de charge (4) est saisie sous forme de grandeur de détection pour la détection du couplage du consommateur (3) à l'interface de charge (4), et
b) dès que le couplage du consommateur (3) a été détecté et que le dispositif d'alimentation (8) a été placé en état de charge,
b1) soit le dispositif d'alimentation (8) est placé de temps à autres dans l'état de non-charge et la procédure de détection selon a) est à nouveau effectuée pendant ce temps,
b2) soit un courant de charge est mesuré et surveillé afin d'empêcher une interruption du processus de charge.

9. Procédé selon la revendication 8, **caractérisé en ce qu'**il est effectué sous la forme d'un procédé actif dans une pause d'interruption d'un procédé passif pour la détection du consommateur (3), dans lequel aucun signal de test (13) n'est créé au niveau de l'interface de charge (4) dans l'état de non-charge du dispositif d'alimentation (8).
